# EUROPEAN PATENT APPLICATION

(11) **EP 4 737 415 A2**
(43) Date of publication of application: **06.05.2026**
(21) Application number: 25211677.7
(22) Date of filing: 28.10.2025
(51) Int. Cl.: C03C 15/00, C03C 23/00, G06F 1/16, H04M 1/02

(54) **COVER WINDOW, METHOD OF MANUFACTURING THE COVER WINDOW, AND ELECTRONIC DEVICE INCLUDING THE COVER WINDOW**

(30) Priority: 31.10.2024 KR 20240152787; 21.11.2024 KR 20240167659
(71) Applicant: Samsung Display Co., Ltd., Yongin-si, Gyeonggi-do 17113 (KR)
(72) Inventor: KIM, Hyung Sik, Giheung-gu, Yongin-si, Gyeonggi-do (KR); KIM, Jeong Ho, Giheung-gu, Yongin-si, Gyeonggi-do (KR); KIM, Jong Ki, Giheung-gu, Yongin-si, Gyeonggi-do (KR); MISHCHIK, Konstantin, Giheung-gu, Yongin-si, Gyeonggi-do (KR); YOO, Kyung Han, Giheung-gu, Yongin-si, Gyeonggi-do (KR); JANG, Seung Hoon, Giheung-gu, Yongin-si, Gyeonggi-do (KR); JUNG, Woo Hyun, Giheung-gu, Yongin-si, Gyeonggi-do (KR)
(74) Representative: Dr. Weitzel & Partner

(57) **Abstract**

A cover window, a method of manufacturing the cover window, and an electronic device including the cover window are provided. The cover window includes a first surface, a second surface facing the first surface, and a plurality of side surfaces between the first surface and the second surface. A radius of curvature of each of the side surfaces is about 15 µm to about 25 µm. A first side surface among the side surfaces comprises a plurality of etch pores. A difference between a maximum height and a minimum height of the etch pores overlapping each other in a direction in which the first side surface extends is about 0.1 µm to about 0.5 µm.

## Description

The present invention relates to a cover window, a method of manufacturing the cover window, and an electronic device including the cover window.

As the information society develops and progresses, demands for display devices for presenting information in the form of images have been continuously increasing in various forms. These display devices may include (e.g., be) liquid crystal displays, field emission displays, and/or light emitting displays. The light emitting displays encompass both organic light-emitting displays, which include organic light-emitting diode elements, and inorganic light-emitting displays, which include inorganic light-emitting diode elements.

To enhance the portability of display devices while providing a wide display screen, flexible display devices, such as bendable or foldable display devices, have been developed and released recently.

In this regard, the cover window of should possess flexible characteristics to enable folding. Additionally, processes such as computer numerical control (CNC) grinding and/or wet-etching of the side surfaces of the cover window are performed to improve the mechanical strength of the cover window. However, defects such as chipping may occur on the side surfaces of the cover window during the CNC process, resulting in higher manufacturing costs.

Aspects and features of embodiments of the present invention are directed toward a cover window which may be manufactured at a reduced cost without a reduction in mechanical strength.

Aspects and features of embodiments of the present invention are directed toward a method of manufacturing a cover window at a reduced cost without a reduction in mechanical strength.

Aspects and features of embodiments of the present invention are directed toward an electronic device including a cover window which may be manufactured at a reduced cost without a reduction in mechanical strength.

The present invention is defined by the features of the independent claims. The dependent claims and the description disclose preferred embodiments. However, embodiments of the present invention are not limited to those set forth herein. The above and other embodiments of the present invention will become more apparent to one of ordinary skill in the art to which the present invention pertains by referencing the detailed description of the present invention provided herein or learning by practice of the presented embodiments of the invention.

According to one or more embodiments of the present invention, a cover window includes a first surface, which may be for example a front surface, a second surface which may be for example a back surface opposite to (e.g., facing away from) the first surface, and a plurality of side surfaces between the first surface and the second surface. A radius of curvature of each of the side surfaces is about 15 micrometers (µm) to about 25 µm (the radius of curvature is also termed as R, such that "R" may be use instead of "µm", for example about 15 R to about 25 R). A first side surface among the side surfaces includes a plurality of etch pores. A difference between a maximum height and a minimum height of the etch pores overlapping each other in a direction in which the first side surface extends is about 0.1 µm to about 0.5 µm.

A difference between a radius of curvature of a second side surface and a radius of curvature of the first side surface among the side surfaces may be about 2.5 µm or less.

A width of the first side surface may be about 10 µm to about 20 µm.

The cover window may have a thickness of about 30 µm to about 60 µm.

According to one or more embodiments of the present invention, a cover window includes a first surface, a second surface opposite to (e.g., facing) the first surface, and a first side surface between (e.g., arranged between) the first surface and the second surface. The first side surface includes a first central side surface having a radius of curvature of about 7 µm to about 13 µm, a first upper side surface between (e.g., arranged between) the first surface and the first central side surface, and a first lower side surface between (e.g., arranged between) the second surface and the first central side surface.

The first upper side surface and the first lower side surface may each be flat.

The first central side surface may include a plurality of etch pores, and a difference between a maximum height and a minimum height of the etch pores in a direction in which the first side surface extends is about 0.1 µm to about 0.5 µm.

A width of the first upper side surface may be greater than a width of the first central side surface.

A width of the first lower side surface may be greater than the width of the first central side surface.

According to one or more embodiments of the present invention, there is provided a method of manufacturing a cover window, the method includes irradiating a laser beam to an area of a mother substrate which corresponds to a plurality of cover windows utilizing a laser device to separate the cover windows from the mother substrate and form laser spots on edges of each of the cover windows, loading the cover windows into a cassette, and etching the cover windows of the cassette utilizing an etchant to reduce a thickness of each of the cover windows and form side surfaces of each of the cover windows.

A radius of curvature of each of the side surfaces of each of the cover windows may be about 15 µm to about 25 µm.

The irradiating of the laser beam to the area of the mother substrate which corresponds to the cover windows utilizing the laser device to separate the cover windows from the mother substrate and form the laser spots on the edges of each of the cover windows may include scanning the laser beam multiple times in an area corresponding to any one of the cover windows.

One scan of the laser beam may include a plurality of first laser spots and a plurality of second laser spots, and the first laser spots and the second laser spots do not overlap each other in a thickness direction of the cover window.

A length of each of the first laser spots and the second laser spots in the thickness direction of the cover window may be about 2 µm to about 20 µm.

In the thickness direction of the cover window, a distance between centers of two neighboring first laser spots among the first laser spots may be about 5 µm to about 15 µm.

A distance between neighboring first laser spots among the first laser spots in a direction orthogonal to the thickness direction of the cover window and a scanning direction of the laser device may be about 0 µm to about 2 µm, and a distance between neighboring first laser spots among the first laser spots in the scanning direction of the laser device may be about 5 µm to about 15 µm.

A distance between neighboring second laser spots among the second laser spots in the scanning direction of the laser device may be about 5 µm to about 15 µm.

At least two second laser spots among the second laser spots may overlap each other in the thickness direction of the cover window.

A minimum distance between the first laser spots and the second laser spots in the direction orthogonal to the thickness direction of the cover window and the scanning direction of the laser device may be about 3 µm or greater.

The sum of the number of first laser spots and the number of second laser spots may be about 10 to about 50.

The number of first laser spots may be different from the number of second laser spots.

the laser beam may have a wavelength range of 800 nanometers (nm) to 1,100 nm.

The scanning of the laser beam multiple times in the area corresponding to any one of the cover windows may include scanning the laser beam along a first side virtual line corresponding to a first side surface of the cover window with the laser device rotated 0 degrees, scanning the laser beam along a first corner virtual line corresponding to a first corner side surface arranged between the first side surface and a second side surface of the cover window while rotating the laser device from 0 degrees to about 90 degrees, and scanning the laser beam along a second side virtual line corresponding to the second side surface of the cover window with the laser device rotated about 90 degrees.

The laser device may output an elliptically polarized laser beam along the first side virtual line, the first corner virtual line, and the second side virtual line.

The scanning of the laser beam multiple times in the area corresponding to any one of the cover windows may further include scanning the laser beam along a second corner virtual line corresponding to a second corner side surface arranged between the second side surface and a third side surface of the cover window while rotating the laser device from about 90 degrees to about 180 degrees, scanning the laser beam along a third side virtual line corresponding to the third side surface of the cover window with the laser device rotated about 180 degrees, scanning the laser beam along a third corner virtual line corresponding to a third corner side surface arranged between the third side surface and a fourth side surface of the cover window while rotating the laser device from about 180 degrees to about 270 degrees, scanning the laser beam along a fourth side virtual line corresponding to the fourth side surface of the cover window with the laser device rotated about 270 degrees, and scanning the laser beam along a fourth corner virtual line corresponding to a fourth corner side surface arranged between the fourth side surface and the first side surface of the cover window while rotating the laser device from about 270 degrees to about 360 degrees.

The laser device may output an elliptically polarized laser beam along the second corner virtual line, the third side virtual line, the third corner virtual line, the fourth side virtual line, and the fourth corner virtual line.

The laser device may include a light source outputting a laser beam, a diffractive element including diffractive patterns which diffract the laser beam, a relay lens relaying the laser beam at a selected ratio, a phase retardation plate retarding a phase of the laser beam incident from the diffractive element, and an objective lens focusing the laser beam incident from the phase retardation plate. The diffractive element may rotate at a selected angle.

The light source may output a laser beam having linear polarization or circular polarization, and the laser beam output from the objective lens may have elliptical polarization.

The phase retardation plate may be a quarter-wave (λ/4) plate.

In one or more embodiments, the relay lens may be between the phase retardation plate and the objective lens.

In one or more embodiments, the relay lens may be between the light source and the diffractive element.

A plurality of etch pores may be formed on each of the side surfaces of each of the cover windows by the etchant.

A difference between a maximum height and a minimum height of the etch pores in a direction in which each of the side surfaces of each of the cover windows extends may be about 0.1 µm to about 0.5 µm.

The thickness of each of the cover windows may be reduced by about 20 % to about 50% by the etchant.

According to one or more embodiments of the present invention, an electronic device includes a display panel including a bendable folding area and a non-folding area around (e.g., arranged around) or beside the folding area, and a cover window on (e.g., arranged on) a surface of the display panel. The cover window includes a first surface, a second surface opposite to (e.g., facing) the first surface, and a plurality of side surfaces between (e.g., arranged between) the first surface and the second surface. A radius of curvature of each of the side surfaces is about 15 µm to about 25 µm, a first side surface among the side surfaces includes a plurality of etch pores, and a difference between a maximum height and a minimum height of the etch pores overlapping each other in a direction in which the first side surface extends is about 0.1 µm to about 0.5 µm.

According to one or more embodiments of the present invention, an electronic device includes a display panel including a bendable folding area and a non-folding area around (e.g., arranged around) or beside the folding area, and a cover window on (e.g., arranged on) a surface of the display panel. The cover window includes a first surface, a second surface opposite to (e.g., facing) the first surface, and a first side surface between (e.g., arranged between) the first surface and the second surface. The first side surface includes a first central side surface having a radius of curvature of about 7 µm to about 13 µm, a first upper side surface between (e.g., arranged between) the first surface and the first central side surface, and a first lower side surface between (e.g., arranged between) the second surface and the first central side surface.

According to the aforementioned and other embodiments of the present invention, the cover window may be formed to have curved side surfaces having a selected radius of curvature only by a laser process using a laser device and an etching process utilizing an etchant. Therefore, when the cover window is manufactured, it may prevent or reduce defects such as chipping due to a CNC process, thereby reducing manufacturing costs.

Furthermore, the laser and etching processes enable precise control over the curvature and smoothness of the side surfaces, ensuring that the cover window maintains its mechanical integrity. The curved side surfaces are designed to absorb impact effectively, which enhances the durability and longevity of the cover window. This is important for flexible display devices that are subject to frequent bending and folding, as it helps prevent damage and maintains the overall strength of the device.

In addition, because side surfaces of the cover window are formed in a curved shape having a selected radius of curvature, they have a shape advantageous for absorbing impact. Accordingly, it may prevent or reduce a reduction in the mechanical strength, such as side strength, of the side surfaces of the cover window.

Moreover, the combination of laser processing and etching allows for the creation of etch pores on the side surfaces, which further contribute to the mechanical strength by providing a controlled surface texture. These etch pores help in dissipating stress and enhancing the overall resilience of the cover window. By enhancing the manufacturing process and incorporating these design elements, the present invention offers a solution for producing high-quality, cost-effective cover windows for flexible display devices.

The patent or application file contains at least one drawing executed in color. Copies of this patent or patent application publication with color drawing(s) will be provided by the Office upon request and payment of the necessary fee.

The accompanying drawings are included to provide a further understanding of the present invention and are incorporated in and constitute a part of the present disclosure. The drawings illustrate embodiments of the present invention and, together with the description, serve to explain principles of the present invention. The above and other embodiments and features of the present invention will become more apparent and appreciated from the following descriptions of example embodiments thereof with reference to the accompanying drawings, in which:
FIGS. 1 and 2 are perspective views of a display module according to one or more embodiments of the present invention;
FIG. 3 is an exploded perspective view of a display module according to one or more embodiments of the present invention;
FIG. 4 is a block diagram of a display module according to one or more embodiments of the present invention;
FIG. 5 is an equivalent circuit diagram of a pixel of a display module according to one or more embodiments of the present invention;
FIG. 6 is an equivalent circuit diagram of a pixel of a display module according to one or more embodiments of the present invention;
FIG. 7 is an equivalent circuit diagram of a pixel of a display module according to one or more embodiments of the present invention;
FIGS. 8 and 9 are cross-sectional views of a display module according to one or more embodiments of the present invention;
FIG. 10 is a detailed cross-sectional view of an example of a display area of the display module illustrated in FIGS. 8 and 9 according to one or more embodiments of the present invention;
FIG. 11 is a cross-sectional view of an example of a display area of the display module illustrated in FIGS. 8 and 9 according to one or more embodiments of the present invention;
FIG. 12 is a detailed cross-sectional view of an example of a light emitting diode element of FIG. 11 according to one or more embodiments of the present invention;
FIGS. 13 and 14 are side views of a display module according to one or more embodiments of the present invention;
FIG. 15 is a cross-sectional view of an example of a display area of the display module illustrated in FIGS. 13 and 14 according to one or more embodiments of the present invention;
FIGS. 16 and 17 are perspective views of a cover window according to one or more embodiments of the present invention;
FIG. 18 is a plan view of a cover window according to one or more embodiments of the present invention;
FIGS. 19 through 22 are cross-sectional views of first through fourth side surfaces of a cover window according to one or more embodiments of the present invention;
FIG. 23 is a detailed cross-sectional view of the first side surface of the cover window of FIG. 19 according to one or more embodiments of the present invention;
FIG. 24 is a detailed three-dimensional (3D) image of the first side surface of the cover window of FIG. 19 according to one or more embodiments of the present invention;
FIG. 25 is an illustrative drawing for explaining the flexural strength of a cover window;
FIG. 26 is a graph illustrating an example of the flexural strength of cover windows according to one or more embodiments of the present invention;
FIG. 27 is a cross-sectional view of an example of a first side surface of a cover window of a first sample according to one or more embodiments of the present invention;
FIG. 28 is an illustrative drawing for explaining a Charpy impact test of a cover window;
FIG. 29 is a graph illustrating an example of the Charpy impact test of cover windows according to one or more embodiments of the present invention;
FIG. 30 is a cross-sectional view of an example of a first side surface of a cover window of a second sample according to one or more embodiments of the present invention;
FIGS. 31 through 34 are side views of first through fourth side surfaces of a cover window according to one or more embodiments of the present invention;
FIG. 35 is a flowchart illustrating a method of manufacturing a cover window according to one or more embodiments of the present invention;
FIGS. 36 through 39 are perspective views for explaining a method of manufacturing a display device according to one or more embodiments of the present invention;
FIG. 40 is a cross-sectional view illustrating an example of a cross section of a mother substrate taken along the line X40-X40' of FIG. 36 according to one or more embodiments of the present invention;
FIG. 41 is a cross-sectional view illustrating an example of a cross section of a cover window taken along the line X41-X41' of FIG. 37 according to one or more embodiments of the present invention;
FIG. 42 is a cross-sectional view illustrating an example of a cross section of a cover window taken along the line X42-X42' of FIG. 39 according to one or more embodiments of the present invention;
FIG. 43 is a perspective view of a laser device according to one or more embodiments of the present invention;
FIG. 44 is an example diagram illustrating the polarization of an output beam according to the rotation of the laser device according to one or more embodiments of the present invention;
FIG. 45 is an example diagram illustrating the polarization of an output beam according to the rotation of the laser device according to one or more embodiments of the present invention;
FIGS. 46 through 53 are perspective views illustrating laser scanning of one cover window cell in more detail according to one or more embodiments of the present invention;
FIGS. 54 through 56 are example drawings illustrating laser spots formed by one laser scan according to one or more embodiments of the present invention;
FIG. 57 is a block diagram of an electronic device according to one or more embodiments of the present invention; and
FIG. 58 is a schematic diagram of electronic devices according to various embodiments of the present invention.

### DETAILED DESCRIPTION

The advantages and features of the present invention, and the methods for achieving them, will become clear with reference to one or more embodiments described herein in more detail with the accompanying drawings. However, the invention is not limited to one or more embodiments disclosed in the description, but may be implemented in one or more suitable different forms, and these embodiments are provided only to make the disclosure of the invention complete and to fully convey and inform those skilled in the art the scope of the present invention, and the disclosure is defined only by the scope of the claims.

When an element or a layer is referred to as "on" another element or layer, it may be directly on the other element or layer, or one or more intervening elements or layers may also be present therebetween. In contrast, "directly on" may refer to that there are no additional intervening elements or layers between the element or layer and the another element or layer. The same or like reference numerals refer to the same or like components throughout the disclosure, and duplicative descriptions thereof may not be provided for conciseness. The shapes, sizes, ratios, angles, numbers, and/or the like disclosed in the drawings for explaining one or more embodiments are mere examples, and therefore the present invention is not limited to the matters illustrated.

Although the terms "first", "second", and/or the like are used to describe one or more suitable components, these components are of course not limited by these terms. These terms are only used to distinguish one component from another. Therefore, it goes without saying that the first component mentioned herein may be the second component within the technical idea of invention.

Each of the features of the one or more suitable embodiments of the present invention may be partially or wholly combined or combined with each other, and one or more suitable technical connections and operations are possible, and each embodiment may be implemented independently of each other or may be implemented together in a related relationship.

One or more embodiments of the present invention will be described in more detail with reference to the accompanying drawings.

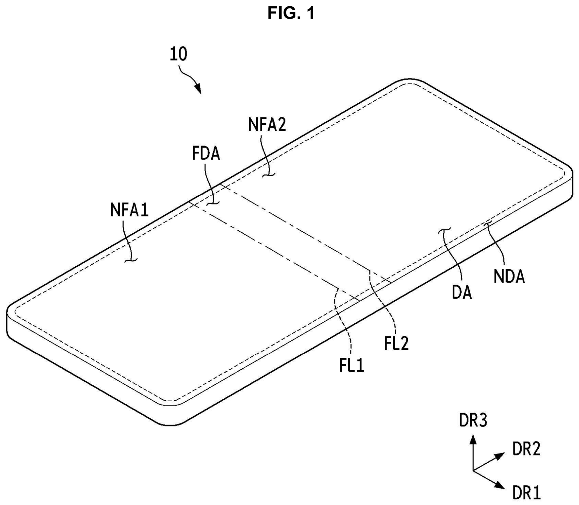

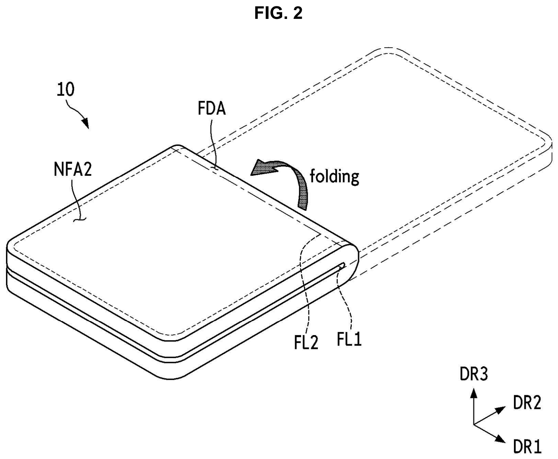

FIGS. 1 and 2 are perspective views of a display module 10 according to one or more embodiments of the present invention.

Referring to FIG. 1 and FIG. 2, the display module 10 according to one or more embodiments may be a module for displaying moving images or still images. The display module 10 according to one or more embodiments may be a foldable display module in a state that is unfolded without being folded at folding lines FL1 and FL2 as illustrated in FIG. 1 or in a state that is folded at the folding lines FL1 and FL2 as illustrated in FIG. 2, but embodiments of the present specification are not limited thereto.

In FIG. 1 and FIG. 2, a first direction DR1 may be a direction parallel to a side (e.g., a short side) of the display module 10 in plan view, for example, may be a horizontal direction of the display module 10. A second direction DR2 may be a direction parallel to another side (e.g., a long side) crossing (e.g., in contact with) the above side (e.g., the short side) of the display module 10 in plan view, for example, may be a vertical direction of the display module 10. In one or more embodiments, the first direction DR1 and the second direction DR2 may be normal to each other. A third direction DR3 may be a thickness direction of the display module 10. In addition, the term "in plan view" may refer to a state, in which it is viewed from the third directional DR3.

The display module 10 may have a quadrilateral shape such as a rectangle shape in plan view. Each corner of the display module 10 may be right-angled or rounded in plan view. A front surface of the display module 10 on which an image is displayed may include two short sides extending in the first direction DR1 and two long sides extending in the second direction DR2.

The display module 10 may include a display area DA and a non-display area NDA. A shape of the display area DA may follow the shape of the display module 10 in plan view. For example, if (e.g., when) the display module 10 is rectangular in plan view, the display area DA may also be rectangular in plan view.

The display area DA may be an area which includes a plurality of pixels to display an image. The non-display area NDA may be an area which does not include pixels and thus does not display an image. In one or more embodiments, the non-display area NDA may be arranged around the display area DA. The non-display area NDA may be around (e.g., surround) the display area DA, but embodiments of the present specification are not limited thereto. In one or more embodiments, the display area DA may be partially surrounded by the non-display area NDA.

The display module 10 may maintain a first state which is an unfolded state or a second state which is a folded state. In one or more embodiments, the display module 10 may be folded in an in-folding manner so that portions of the display area DA face each other as illustrated in FIG. 2. In these embodiments, portions of the front surface of the display module 10 may face each other if (e.g., when) the display module 10 is folded. In one or more embodiments, the display module 10 may be folded in an out-folding manner so that portions of a back surface of the display module 10 face each other.

The display module 10 may include a folding area FDA, a first non-folding area NFA1, and a second non-folding area NFA2. The folding area FDA may be an area in which the display module 10 is bent or folded. The first non-folding area NFA1 and the second non-folding area NFA2 may each be an area in which the display module 10 is not bent or folded. In one or more embodiments, the first non-folding area NFA1 and the second non-folding area NFA2 may each be a flat area of the display module 10.

The first non-folding area NFA1 may be arranged on a side, e.g., a lower side of the folding area FDA. The second non-folding area NFA2 may be arranged on the other side, e.g., an upper side of the folding area FDA. The folding area FDA may be an area which is defined by a first folding line FL1 and a second folding line FL2 and an area in which the display module 10 is bent with a selected radius of curvature. The first folding line FL1 may be a boundary between the folding area FDA and the first non-folding area NFA1, and the second folding line FL2 may be a boundary between the folding area FDA and the second non-folding area NFA2.

In one or more embodiments, the first folding line FL1 and the second folding line FL2 may each extend in the first direction DR1 as illustrated in FIG. 1 and FIG. 2. In these embodiments, the display module 10 may be folded based on the first direction DR1. Therefore, because a length of the display module 10 in the second direction DR2 may be reduced by about half, a user can easily carry the display module 10.

When the first folding line FL1 and the second folding line FL2 extend in the first direction DR1 as illustrated in FIG. 1 and FIG. 2, a length of the folding area FDA in the first direction DR1 may be greater than a length of the folding area FDA in the second direction DR2. In one or more embodiments, a length of the first non-folding area NFA1 in the second direction DR2 may be greater than a length of the first non-folding area NFA1 in the first direction DR1. A length of the second non-folding area NFA2 in the second direction DR2 may be greater than a length of the second non-folding area NFA2 in the first direction DR1.

Each of the display area DA and the non-display area NDA may overlap at least one of the folding area FDA, the first non-folding area NFA1, or the second non-folding area NFA2. In FIG. 1 and FIG. 2, each of the display area DA and the non-display area NDA overlaps the folding area FDA, the first non-folding area NFA1, and the second non-folding area NFA2.

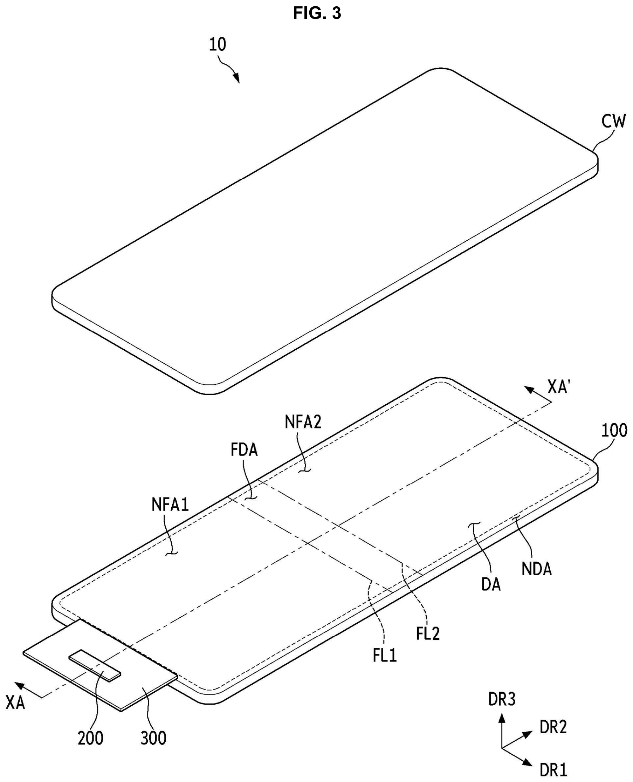

FIG. 3 is an exploded perspective view of the display module 10 according to one or more embodiments of the present invention.

Referring to FIG. 3, the display module 10 according to one or more embodiments includes a cover window CW, a display panel 100, a driving circuit 200, and a circuit board 300.

The display panel 100 may be a light emitting display device such as an organic light emitting display device using an organic light emitting diode, a quantum dot light emitting display device including a quantum dot light emitting layer, an inorganic light emitting display device including an inorganic semiconductor, or a micro- or nano-light emitting display device using a micro- or nano-light emitting diode.

The display panel 100 may be shaped like a rectangular plane having long sides in the second direction DR2 and short sides in the first direction DR1. Each corner where a long side extending in the second direction DR2 meets a short side extending in the first direction DR1 may be right-angled or may be rounded to have a curvature. A planar shape of the display panel 100 is not limited to a quadrilateral shape, for example, may also be other polygonal shapes, a circular shape, or an elliptical shape.

The display panel 100 may be formed flat, but embodiments of the present invention are not limited thereto. For example, in one or more embodiments, the display panel 100 may include a curved portion formed at left end and right end and having a constant or varying curvature. In one or more embodiments, at least a portion of the display panel 100 may be curved, bent, folded, or rolled.

The display panel 100 may include a display area DA displaying an image and a non-display area NDA arranged around the display area DA.

The display area DA may occupy most of the area of the display panel 100. The display area DA may be arranged in a center of the display panel 100. Each of pixels including a plurality of emission areas may be arranged in the display area DA to display an image.

The non-display area NDA may neighbor the display area DA. The non-display area NDA may be an area outside (e.g., adjacent) the display area DA. In one or more embodiments, the non-display area NDA may be around (e.g., surround) the display area DA. The non-display area NDA may be an edge area of the display panel 100.

Display pads to be connected to the circuit board 300 may be arranged in the non-display area NDA. The display pads may be arranged at an edge of the display panel 100. For example, in one or more embodiments, the display pads may be arranged at a lower edge of the display panel 100.

The driving circuit 200 may be formed as an integrated circuit (IC). In one or more embodiments, the driving circuit 200 may be attached to the circuit board 300 using a chip on plastic (COP) method. The driving circuit 200 may generate data voltages, power supply voltages, scan timing signals, and/or the like and output the data voltages, the power supply voltages, the scan timing signals, and/or the like to the display panel 100.

The circuit board 300 may be arranged on the display pads arranged at an edge of the display panel 100. The circuit board 300 may be attached onto the display pads using a conductive adhesive member such as an anisotropic conductive film or an anisotropic conductive adhesive. Accordingly, the circuit board 300 may be electrically connected to the display panel 100. The circuit board 300 may be a flexible printed circuit board or a flexible film such as a chip on film.

The cover window CW may be arranged on a front surface of the display panel 100 to protect the front surface of the display panel 100 from external impact. The cover window CW may be made of a transparent material. For example, in one or more embodiments, the cover window CW may be glass. In these embodiments, the cover window CW may be ultra-thin glass (UTG) having a thickness of about 250 µm or less in order to have flexible characteristics that make it foldable.

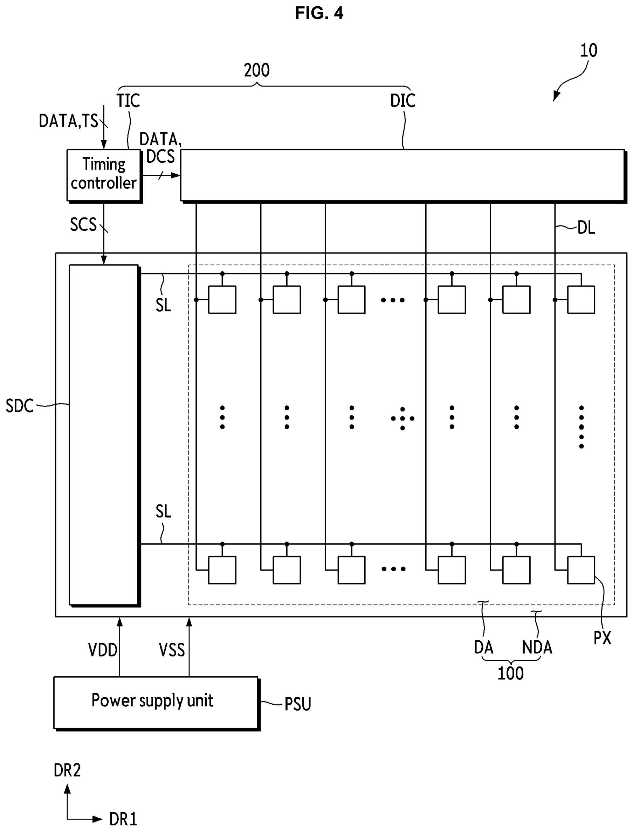

FIG. 4 is a block diagram of the display module 10 according to one or more embodiments of the present invention.

Referring to FIG. 4, the display module 10 according to one or more embodiments may include the display panel 100, a scan driving circuit unit SDC, the driving circuit 200, and a power supply unit PSU.

The display panel 100 may include data lines DL, scan lines SL, and pixels PX. The scan lines SL may extend in the first direction DR1 and may be arranged in the second direction DR2. The data lines DL may extend in the second direction DR2 and may be arranged in the first direction DR1.

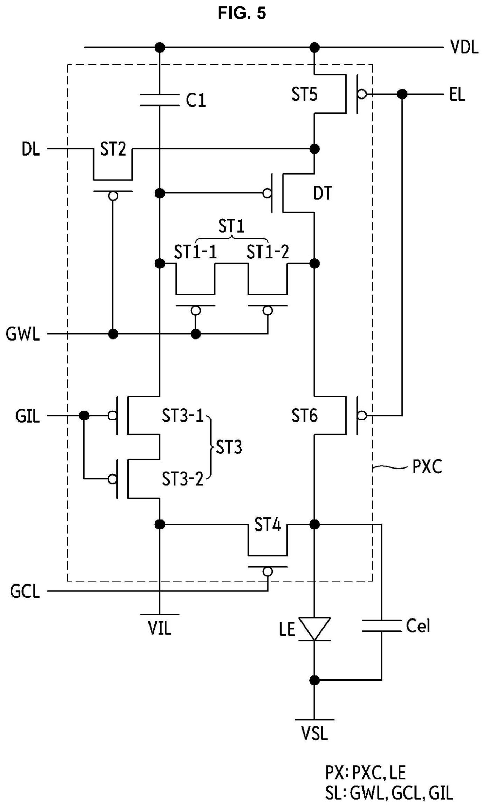

Each of the pixels PX may be connected to at least any one of the data lines DL and at least any one of the scan lines SL. Each of the pixels PX may include a light emitting element LE and a pixel circuit unit PXC including a plurality of transistors for supplying a driving current to the light emitting element LE, as illustrated in FIGS. 5 through 7. The pixels PX will be described in more detail later with reference to FIGS. 5 through 7.

The scan driving circuit unit SDC and the driving circuit 200 may be referred to as a display panel driving unit. The driving circuit 200 may include a timing control circuit unit (i.e., timing controller) TIC and a data driving circuit unit DIC.

The scan driving circuit unit SDC is connected to the scan lines SL to transmit scan signals. The scan driving circuit unit SDC may generate scan signals according to a scan timing control signal SCS input from the timing control circuit unit TIC and output the scan signals to the scan lines SL.

The scan driving circuit unit SDC may include a plurality of transistors. In this regard, the scan driving circuit unit SDC may be arranged in the non-display area NDA on left and/or right sides of the display panel 100.

The data driving circuit unit DIC is connected to the data lines DL to supply data voltages. The data driving circuit unit DIC receives digital video data DATA and a data timing control signal DCS from the timing control circuit unit TIC. The data driving circuit unit DIC converts the digital video data DATA into data voltages according to the data timing control signal DCS and outputs the data voltages to the data lines DL.

The timing control circuit unit TIC receives the digital video data DATA and timing signals TS. The timing signals TS may include a vertical sync signal, a horizontal sync signal, a data enable signal, and a clock signal such as a dot clock.

The timing control circuit unit TIC generates control signals for controlling operation timings of the data driving circuit unit DIC and the scan driving circuit unit SDC. The control signals may include the data timing control signal DCS for controlling the operation timing of the data driving circuit unit DIC and the scan timing control signal SCS for controlling the operation timing of the scan driving circuit unit SDC.

The timing control circuit unit TIC outputs the digital video data DATA and the data timing control signal DCS to the data driving circuit unit DIC and outputs the scan timing control signal SCS to the scan driving circuit unit SDC.

The power supply unit PSU may generate a first power supply voltage VSS corresponding to a low potential voltage and a second power supply voltage VDD corresponding to a high potential voltage from main power applied from the outside. In addition, the power supply unit PSU may supply one or more suitable driving voltages to the data driving circuit unit DIC, the scan driving circuit unit SDC, and the timing control circuit unit TIC.

FIG. 5 is an equivalent circuit diagram of a pixel PX of the display module 10 according to one or more embodiments of the present invention.

Referring to FIG. 5, a pixel PX according to one or more embodiments may include a pixel circuit unit PXC and a light emitting element LE.

The light emitting element LE emits light according to a driving current (Ids). The amount of light emitted from the light emitting element LE may be proportional to the driving current (Ids).

In one or more embodiments, the light emitting element LE may be an organic light emitting element including an anode, a cathode, and an organic light emitting layer arranged between the anode and the cathode. In one or more embodiments, the light emitting element LE may be an inorganic light emitting element including an anode, a cathode, and an inorganic semiconductor arranged between the anode and the cathode.

The anode of the light emitting element LE may be connected to a first electrode of a fourth transistor ST4 and a second electrode of a sixth transistor ST6, and the cathode of the light emitting element LE may be connected to a first power line VSL. A parasitic capacitance Cel may be formed between the anode and the cathode of the light emitting element LE.

The pixel circuit unit PXC may include a driving transistor DT, switch elements, and a capacitor C1. The switch elements may include first through sixth transistors ST1 through ST6. In one or more embodiments, the first transistor ST1 may include a first-first transistor ST1-1 and a first-second transistor ST1-2 connected in series. The third transistor ST3 may include a third-first transistor ST3-1 and a third-second transistor ST3-2 connected in series.

The driving transistor DT includes a gate electrode, a first electrode, and a second electrode. The driving transistor DT controls a driving current flowing between the first electrode and the second electrode according to a data voltage applied to the gate electrode.

The capacitor C1 is formed between the second electrode of the driving transistor DT and a second power line VDL. One electrode of the capacitor C1 may be connected to the second electrode of the driving transistor DT, and the other electrode of the capacitor C1 may be connected to the second power line VDL.

In one or more embodiments, if (e.g., when) a first electrode of each of the first through sixth transistors ST1 through ST6 and the driving transistor DT is a source electrode, their respective second electrode may be a drain electrode. In one or more embodiments, if (e.g., when) the first electrode of each of the first through sixth transistors ST1 through ST6 and the driving transistor DT is a drain electrode, their respective second electrode may be a source electrode.

An active layer of each of the first through sixth transistors ST1 through ST6 and the driving transistor DT may be made of any one selected from among polysilicon, amorphous silicon, and an oxide semiconductor. If (e.g., when) the active layer of each of the first through sixth transistors ST1 through ST6 and the driving transistor DT is made of polysilicon, a process for forming the active layer may be a low-temperature polysilicon (LTPS) process.

In addition, although an embodiments in which the first through sixth transistors ST1 through ST6 and the driving transistor DT are formed as P-type (kind) metal oxide semiconductor field effect transistors (MOSFETs) has been mainly described in FIG. 5, embodiments of the present specification are not limited thereto, for example, in one or more embodiments, they may also be formed as N-type (kind) MOSFETs.

Furthermore, a first power supply voltage VSS of the first power line VSL, a second power supply voltage VDD of the second power line VDL, and a third power supply voltage (or an initialization voltage) of a third power line VIL may be set in consideration of the characteristics of the driving transistor DT, the characteristics of the light emitting element LE, and/or the like.

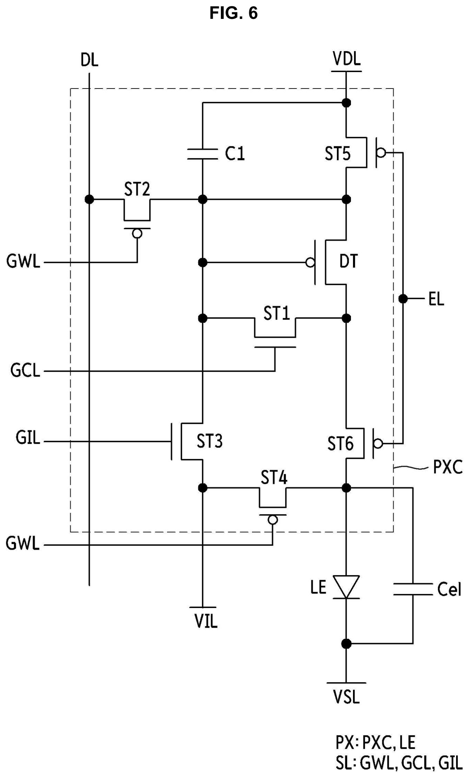

FIG. 6 is an equivalent circuit diagram of a pixel of a display module according to one or more embodiments of the present invention.

The embodiment of FIG. 6 is different from the embodiment of FIG. 5 in that a driving transistor DT, a second transistor ST2, a fourth transistor ST4, a fifth transistor ST5, and a sixth transistor ST6 are each formed as P-type (kind) MOSFETs, and a first transistor ST1 and a third transistor ST3 are each formed as N-type (kind) MOSFETs.

Referring to FIG. 6, an active layer of each of the driving transistor DT, the second transistor ST2, the fourth transistor ST4, the fifth transistor ST5, and the sixth transistor ST6 formed as P-type (kind) MOSFETs may be made of polysilicon, and an active layer of each of the first transistor ST1 and the third transistor ST3 formed as N-type (kind) MOSFETs may be made of an oxide semiconductor.

The embodiment of FIG. 6 is different from the embodiment of FIG. 5 in that a gate electrode of the second transistor ST2 and a gate electrode of the fourth transistor ST4 are connected to a write scan line GWL, and a gate electrode of the first transistor ST1 is connected to a control scan line GCL. In addition, in FIG. 6, because the first transistor ST1 and the third transistor ST3 are formed as N-type (kind) MOSFETs, a scan signal of a gate high voltage may be transmitted as a gate-on voltage signal to the control scan line GCL and an initialization scan line GIL. In contrast, because the second transistor ST2, the fourth transistor ST4, the fifth transistor ST5, and the sixth transistor ST6 are formed as P-type (kind) MOSFETs, a scan signal of a gate low voltage may be transmitted as a gate-on voltage signal to the write scan line GWL and an emission line EL.

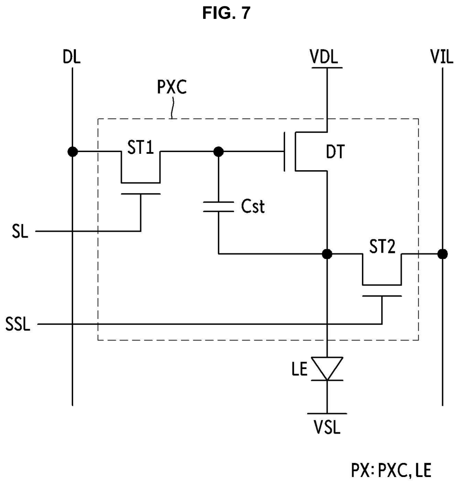

FIG. 7 is an equivalent circuit diagram of a pixel of a display module according to one or more embodiments of the present invention.

Referring to FIG. 7, a light emitting element LE emits light according to a driving current (Ids). The amount of light emitted from the light emitting element LE may be proportional to the driving current (Ids). An anode of the light emitting element LE may be connected to a source electrode of a driving transistor DT, and a cathode may be connected to a first power line VSL to which a first power supply voltage VSS lower than a second power supply voltage VDD is supplied.

The driving transistor DT adjusts a current flowing from a second power line VDL, to which the second power supply voltage VDD is supplied, to the light emitting element LE according to a voltage difference between a gate electrode and the source electrode of the driving transistor DT. The gate electrode of the driving transistor DT may be connected to a first electrode of a first transistor ST1, the source electrode of the driving transistor DT may be connected to the anode of the light emitting element LE, and a drain electrode may be connected to the second power line VDL.

The first transistor ST1 is turned on by a scan signal of a scan line SL to connect a data line DL to the gate electrode of the driving transistor DT. A gate electrode of the first transistor ST1 may be connected to the scan line SL, the first electrode of the first transistor ST1 may be connected to the gate electrode of the driving transistor DT, and a second electrode of the first transistor ST1 may be connected to the data line DL.

A second transistor ST2 is turned on by a sensing signal of a sensing signal line SSL to connect an initialization voltage line VIL to the source electrode of the driving transistor DT. A gate electrode of the second transistor ST2 may be connected to the sensing signal line SSL, a first electrode of the second transistor ST2 may be connected to the initialization voltage line VIL, and a second electrode of the second transistor ST2 may be connected to the source electrode of the driving transistor DT.

The first electrode of each of the first and second transistors ST1 and ST2 may be a source electrode, and their respective second electrode may be a drain electrode. However, it should be noted that embodiments of the present specification are not limited thereto. For example, in one or more embodiments, the first electrode of each of the first and second transistors ST1 and ST2 may be a drain electrode, and their respective second electrode may be a source electrode.

A capacitor Cst is formed between the gate electrode and the source electrode of the driving transistor DT. The capacitor Cst stores a difference voltage between a gate voltage and a source voltage of the driving transistor DT.

Although an embodiment in which the driving transistor DT and the first and second transistors ST1 and ST2 are each formed as N-type (kind) MOSFETs has been mainly described in FIG. 7, it should be noted that embodiments of the present specification are not limited thereto. In one or more embodiments, the driving transistor DT and the first and second transistors ST1 and ST2 may also be formed as p-type (kind) MOSFETs.

It should be noted that a pixel PX according to one or more embodiments of the present specification is not limited to those illustrated in FIGS. 5 through 7. The pixel PX according to one or more embodiments of the present specification may have other suitable circuit structures that can be adopted by those skilled in the art, in addition to one or more embodiments illustrated in FIGS. 5 through 7.

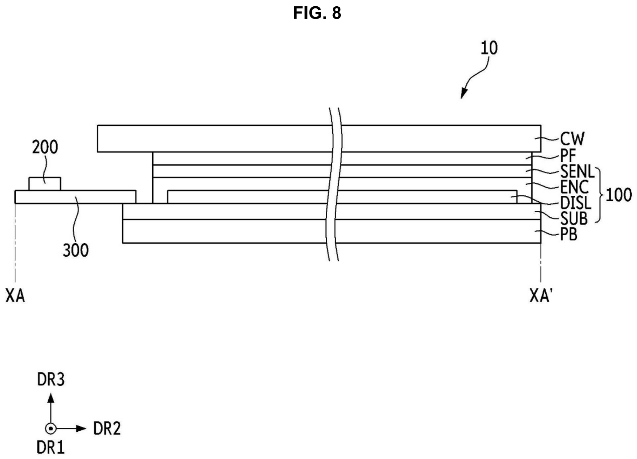

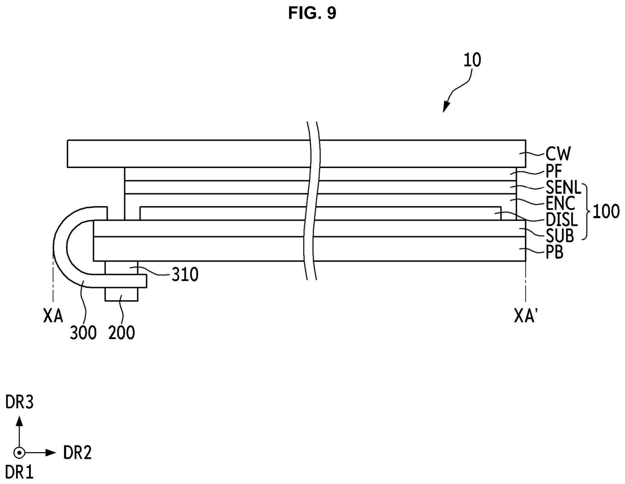

FIGS. 8 and 9 are cross-sectional views of a display module 10 according to one or more embodiments of the present invention.

FIGS. 8 and 9 illustrate an example of the display module 10 cut along line XA-XA' of FIG. 3 according to one or more embodiments. FIG. 9 is a cross-sectional view of an example of the display module 10 in which a circuit board 300 in FIG. 8 is bent.

Referring to FIG. 8 and FIG. 9, the display module 10 according to one or more embodiments may include a display panel 100, a polarizing film PF, a cover window CW, and an under-panel cover PB. The display panel 100 may include a substrate SUB, a display layer DISL, an encapsulation layer ENC, and a sensor electrode layer SENL.

The substrate SUB may be a flexible substrate that may be stretched and/or bent. The substrate SUB may be made of an insulating material. For example, in one or more embodiments, the substrate SUB may be made of a polymer resin such as an acryl resin, an epoxy resin, a phenolic resin, a polyamide resin, or a polyimide resin.

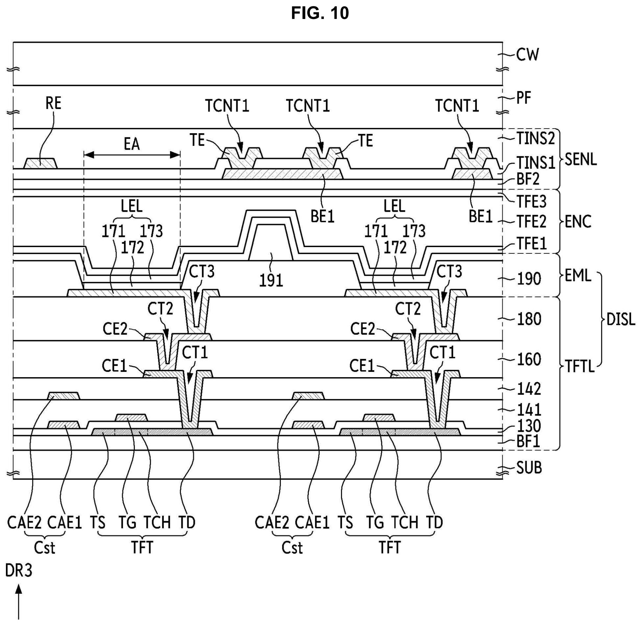

The display layer DISL may be arranged on a first surface of the substrate SUB. The display layer DISL may be a layer that displays an image. The display layer DISL may include a thin-film transistor layer TFTL (see FIG. 10) in which thin-film transistors are formed and a light emitting element layer EML (see FIG. 10) in which light emitting elements emitting light are arranged in emission areas.

In a display area DA of the display layer DISL, scan lines, data lines, power lines, and/or the like may be arranged so that the emission areas may emit light. In a non-display area NDA of the display layer DISL, a scan driving circuit unit outputting scan signals to the scan lines and fan-out lines connecting the data lines and a driving circuit 200 may be arranged.

The encapsulation layer ENC may be a layer for encapsulating the light emitting element layer EML of the display layer DISL to prevent or reduce penetration of oxygen and/or moisture into the light emitting element layer EML of the display layer DISL. The encapsulation layer ENC may be arranged on the display layer DISL. The encapsulation layer ENC may be arranged on upper and side surfaces of the display layer DISL. The encapsulation layer ENC may cover the display layer DISL.

The sensor electrode layer SENL may be arranged on the display layer DISL. The sensor electrode layer SENL may include sensor electrodes. The sensor electrode layer SENL may sense a user's touch using the sensor electrodes.

The polarizing film PF may be arranged on the display panel 100 to prevent or reduce the visibility of an image displayed on the display panel 100 from being reduced by external light reflected from the display panel 100. The polarizing film PF may include a first base member, a linear polarizer, a phase retardation film such as a quarter-wave (λ/4) plate, and a second base member. The first base member, the phase retardation film, the linear polarizer, and the second base member of the polarizing film PF may be sequentially stacked on the display panel 100.

The cover window CW may be arranged on the polarizing film PF. The cover window CW may be attached onto the polarizing film PF by a transparent adhesive member such as an optically clear adhesive (OCA) film or an optically clear resin (OCR).

The under-panel cover PB may be arranged on a second surface of the substrate SUB of the display panel 100. The second surface of the substrate SUB may be a surface opposite the first surface. The under-panel cover PB may be attached to the second surface of the substrate SUB of the display panel 100 through an adhesive member. The adhesive member may be a pressure sensitive adhesive.

The under-panel cover PB may include at least one of a light blocking member for absorbing light incident from the outside, a buffer member for absorbing external impact, or a heat dissipation member for efficiently dissipating the heat of the display panel 100.

The light blocking member may be arranged under the display panel 100. The light blocking member blocks transmission of light to prevent elements arranged under the light blocking member, for example, the circuit board 300 from being seen from above the display panel 100. The light blocking member may include a light absorbing material such as a black pigment and/or a black dye.

The buffer member may be arranged under the light blocking member. The buffer member absorbs external impact to prevent or reduce the display panel 100 from being damaged. The buffer member may be composed of a single layer or a plurality of layers. For example, the buffer member may be made of a polymer resin such as polyurethane, polycarbonate, polypropylene, or polyethylene or may be made of an elastic material such as a rubber, a urethane-based material, or a sponge formed by foaming an acryl-based material.

The heat dissipation member may be arranged under the buffer member. The heat dissipation member may include a first heat dissipation layer including graphite and/or carbon nanotubes and a second heat dissipation layer formed of a thin metal film such as copper, nickel, ferrite, and/or silver that may shield electromagnetic waves and has excellent or suitable thermal conductivity.

The circuit board 300 may be bent toward the bottom of the display panel 100 as illustrated in FIG. 9. In one or more embodiments, the circuit board 300 may be attached to a lower surface of the under-panel cover PB by an adhesive member 310. The adhesive member 310 may be a pressure sensitive adhesive.

FIG. 10 is a detailed cross-sectional view of an example of a display area of the display module 10 illustrated in FIG. 8 and FIG. 9 according to one or more embodiments of the present invention.

Referring to FIG. 10, a display panel 100 (see FIGS. 8 and 9) according to one or more embodiments may be an organic light emitting display panel including light emitting elements LEL, each including an organic light emitting layer 172.

A display layer DISL may include a thin-film transistor layer TFTL including a plurality of thin-film transistors and a light emitting element layer EML including a plurality of light emitting elements.

A first buffer layer BF1 may be arranged on a substrate SUB. In one or more embodiments, the first buffer layer BF1 may be made of an inorganic material such as a silicon nitride layer, a silicon oxynitride layer, a silicon oxide layer, a titanium oxide layer, or an aluminum oxide layer. In one or more embodiments, the first buffer layer BF1 may be a multilayer in which a plurality of layers selected from among a silicon nitride layer, a silicon oxynitride layer, a silicon oxide layer, a titanium oxide layer, and an aluminum oxide layer are alternately stacked.

An active layer including a channel region TCH, a source region TS, and a drain region TD of each thin-film transistor TFT may be arranged on the first buffer layer BF1. The active layer may be made of polycrystalline silicon, monocrystalline silicon, low-temperature polycrystalline silicon, amorphous silicon, or an oxide semiconductor material. If (e.g., when) the active layer includes polycrystalline silicon or an oxide semiconductor material, the source region TS and the drain region TD in the active layer may be conductive regions doped with ions or impurities to have relatively high conductivity.

A gate insulating layer 130 may be arranged on the active layers of the thin-film transistors TFT. The gate insulating layer 130 may be made of an inorganic layer, for example, a silicon nitride layer, a silicon oxynitride layer, a silicon oxide layer, a titanium oxide layer, or an aluminum oxide layer.

A first gate metal layer including gate electrodes TG of the thin-film transistors TFT, first capacitor electrodes CAE1 of capacitors Cst, and scan lines may be arranged on the gate insulating layer 130. The gate electrode TG of each thin-film transistor TFT may overlap the respective channel region TCH in the third direction DR3. The first gate metal layer may be a single layer or a multilayer made of any one or more selected from among molybdenum (Mo), aluminum (Al), chromium (Cr), gold (Au), titanium (Ti), nickel (Ni), neodymium (Nd), copper (Cu), and alloys thereof.

A first interlayer insulating layer 141 may be arranged on the first gate metal layer. The first interlayer insulating layer 141 may be made of an inorganic layer, for example, a silicon nitride layer, a silicon oxynitride layer, a silicon oxide layer, a titanium oxide layer, or an aluminum oxide layer. In one or more embodiments, the first interlayer insulating layer 141 may include a plurality of inorganic layers.

A second gate metal layer including second capacitor electrodes CAE2 of the capacitors Cst may be arranged on the first interlayer insulating layer 141. The second capacitor electrodes CAE2 may overlap the first capacitor electrodes CAE1 in the third direction DR3. Therefore, the first capacitor electrodes CAE1, the second capacitor electrodes CAE2, and inorganic insulating dielectric layers (e.g., the first interlayer insulating layer 141) arranged between the first and second capacitor electrodes CAE1 and CAE2 to serve as dielectric layers may form the capacitors Cst. The second gate metal layer may be a single layer or a multilayer made of any one or more selected from among molybdenum (Mo), aluminum (Al), chromium (Cr), gold (Au), titanium (Ti), nickel (Ni), neodymium (Nd), copper (Cu), and alloys thereof.

A second interlayer insulating layer 142 may be arranged on the second gate metal layer. The second interlayer insulating layer 142 may be made of an inorganic layer, for example, a silicon nitride layer, a silicon oxynitride layer, a silicon oxide layer, a titanium oxide layer, or an aluminum oxide layer. In one or more embodiments, the second interlayer insulating layer 142 may include a plurality of inorganic layers.

A first data metal layer including first connection electrodes CE1 and data lines may be arranged on the second interlayer insulating layer 142. The first connection electrodes CE1 may be connected to the drain regions TD through first contact holes CT1 penetrating the gate insulating layer 130, the first interlayer insulating layer 141, and the second interlayer insulating layer 142. The first data metal layer may be a single layer or a multilayer made of any one or more selected from among molybdenum (Mo), aluminum (Al), chromium (Cr), gold (Au), titanium (Ti), nickel (Ni), neodymium (Nd), copper (Cu), and alloys thereof.

A first organic layer 160 may be arranged on the first connection electrodes CE1 to flatten steps caused by the thin-film transistors TFT. The first organic layer 160 may be made of an organic layer such as an acryl resin, an epoxy resin, a phenolic resin, a polyamide resin, or a polyimide resin.

A second data metal layer including second connection electrodes CE2 may be arranged on the first organic layer 160. The second data metal layer may be connected to the first connection electrodes CE1 through second contact holes CT2 penetrating the first organic layer 160. The second data metal layer may be a single layer or a multilayer made of any one or more selected from among molybdenum (Mo), aluminum (Al), chromium (Cr), gold (Au), titanium (Ti), nickel (Ni), neodymium (Nd), copper (Cu), and alloys thereof.

A second organic layer 180 may be arranged on the second connection electrodes CE2. The second organic layer 180 may be made of an organic layer such as an acryl resin, an epoxy resin, a phenolic resin, a polyamide resin, or a polyimide resin.

The light emitting element layer EML is arranged on the thin-film transistor layer TFTL. The light emitting element layer EML may include the light emitting elements LEL and a bank 190.

Each of the light emitting elements LEL may include a pixel electrode 171, a light emitting layer 172, and a common electrode 173. Each emission area EA refers to an area in which the pixel electrode 171, the light emitting layer 172, and the common electrode 173 are sequentially stacked so that holes from the pixel electrode 171 and electrons from the common electrode 173 are combined with each other in the light emitting layer 172 to emit light. In this regard, the pixel electrode 171 may be an anode, and the common electrode 173 may be a cathode.

A pixel electrode layer including the pixel electrodes 171 may be formed on the second organic layer 180. The pixel electrodes 171 may be connected to the second connection electrodes CE2 through third contact holes CT3 penetrating the second organic layer 180. The pixel electrode layer may be a single layer or a multilayer made of any one or more selected from among molybdenum (Mo), aluminum (Al), chromium (Cr), gold (Au), titanium (Ti), nickel (Ni), neodymium (Nd), copper (Cu), and alloys thereof.

In a top emission structure in which light is emitted in a direction from the light emitting layers 172 toward the common electrode 173, each of the pixel electrodes 171 may be formed as a single layer of molybdenum (Mo), titanium (Ti), copper (Cu), or aluminum (Al) or, in order to increase reflectivity, may be formed as a stacked structure (Ti/Al/Ti) of aluminum and titanium, a stacked structure (ITO/Al/ITO) of aluminum and indium tin oxide, an APC alloy, or a stacked structure (ITO/APC/ITO) of an APC alloy and indium tin oxide. The APC alloy is an alloy of silver (Ag), palladium (Pd), and copper (Cu).

The bank 190 serves to define the emission areas EA of pixels. In this regard, the bank 190 may be formed on the second organic layer 180 to partially expose the pixel electrodes 171. The bank 190 may cover edges of the pixel electrodes 171. The bank 190 may be arranged in the third contact holes CT3. For example, in one or more embodiments, the third contact holes CT3 may be filled with a material included in the bank 190. The bank 190 may be made of an organic layer such as an acryl resin, an epoxy resin, a phenolic resin, a polyamide resin, or a polyimide resin.

A spacer 191 may be arranged on the bank 190. The spacer 191 may support a mask during a process of fabricating the light emitting layers 172. The spacer 191 may be made of an organic layer such as an acryl resin, an epoxy resin, a phenolic resin, a polyamide resin, or a polyimide resin.

The light emitting layers 172 are formed on the pixel electrodes 171. The light emitting layers 172 may include an organic material to emit light of a selected color. For example, each of the light emitting layers 172 may include a hole transporting layer, an organic material layer, and an electron transporting layer. The organic material layer may include a host and a dopant. The organic material layer may include a material that emits light with a selected color and may be formed using a phosphorescent material and/or a fluorescent material.

The common electrode 173 is formed on the light emitting layers 172. The common electrode 173 may be formed to cover the light emitting layers 172. The common electrode 173 may be a common layer commonly formed in all emission areas. In one or more embodiments, a capping layer may be formed on the common electrode 173.

In the top emission structure, the common electrode 173 may be made of a transparent conductive material (TCO) that may transmit light, such as indium tin oxide (ITO) or indium zinc oxide (IZO), or may be made of a semi-transmissive conductive material such as magnesium (Mg), silver (Ag), or an alloy of Mg and Ag. If (e.g., when) the common electrode 173 is made of a semi-transmissive conductive material, light output efficiency may be increased by a microcavity.

An encapsulation layer ENC may be formed on the light emitting element layer EML. The encapsulation layer ENC may include at least one selected from among inorganic layer TFE1 and TFE3 to prevent or reduce oxygen and/or moisture from penetrating into the light emitting element layer EML. In addition, the encapsulation layer ENC may include at least one organic layer to protect the light emitting element layer EML from foreign substances such as dust. For example, in one or more embodiments, the encapsulation layer ENC may include a first encapsulating inorganic layer TFE1, an encapsulating organic layer TFE2, and a second encapsulating inorganic layer TFE3.

The first encapsulating inorganic layer TFE1 may be arranged on the common electrode 173, the encapsulating organic layer TFE2 may be arranged on the first encapsulating inorganic layer TFE1, and the second encapsulating inorganic layer TFE3 may be arranged on the encapsulating organic layer TFE2. In one or more embodiments, each of the first encapsulating inorganic layer TFE1 and the second encapsulating inorganic layer TFE3 may be a multilayer in which one or more inorganic layers selected from among a silicon nitride layer, a silicon oxynitride layer, a silicon oxide layer, a titanium oxide layer, and an aluminum oxide layer are alternately stacked. The encapsulating organic layer TFE2 may be an organic layer such as an acryl resin, an epoxy resin, a phenolic resin, a polyamide resin, or a polyimide resin.

A sensor electrode layer SENL is arranged on the encapsulation layer ENC. The sensor electrode layer SENL may include sensor electrodes TE and RE.

A second buffer layer BF2 may be arranged on the encapsulation layer ENC. The second buffer layer BF2 may include at least one inorganic layer. For example, in one or more embodiments, the second buffer layer BF2 may be a multilayer in which one or more inorganic layers selected from among a silicon nitride layer, a silicon oxynitride layer, a silicon oxide layer, a titanium oxide layer, and an aluminum oxide layer are alternately stacked. In one or more embodiments, the second buffer layer BF2 may not be provided.

First connection portions BE1 may be arranged on the second buffer layer BF2. Each of the first connection portions BE1 may be formed as a single layer of molybdenum (Mo), titanium (Ti), copper (Cu), or aluminum (Al) or may be formed as a stacked structure (Ti/Al/Ti) of aluminum and titanium, a stacked structure (ITO/Al/ITO) of aluminum and indium tin oxide, an APC alloy, or a stacked structure (ITO/APC/ITO) of an APC alloy and indium tin oxide.

A first sensor insulating layer TINS1 may be arranged on the first connection portions BE1. The first sensor insulating layer TINS1 may be made of an inorganic layer, for example, a silicon nitride layer, a silicon oxynitride layer, a silicon oxide layer, a titanium oxide layer, or an aluminum oxide layer.

Sensor electrodes, that is, driving electrodes TE and sensing electrodes RE may be arranged on the first sensor insulating layer TNIS1. In addition, dummy patterns may be arranged on the first sensor insulating layer TNIS1. The driving electrodes TE, the sensing electrodes RE, and the dummy patterns do not overlap the emission areas EA. Each of the driving electrodes TE, the sensing electrodes RE, and the dummy patterns may be formed as a single layer of molybdenum (Mo), titanium (Ti), copper (Cu), or aluminum (Al) or may be formed as a stacked structure (Ti/Al/Ti) of aluminum and titanium, a stacked structure (ITO/Al/ITO) of aluminum and indium tin oxide, an APC alloy, or a stacked structure (ITO/APC/ITO) of an APC alloy and indium tin oxide.

A second sensor insulating layer TINS2 may be arranged on the driving electrodes TE, the sensing electrodes RE, and the dummy patterns. The second sensor insulating layer TINS2 may include at least one of an inorganic layer or an organic layer. The inorganic layer may be a silicon nitride layer, a silicon oxynitride layer, a silicon oxide layer, a titanium oxide layer, or an aluminum oxide layer. The organic layer may be an acryl resin, an epoxy resin, a phenolic resin, a polyamide resin, or a polyimide resin. The polarizing film PF may be arranged on the second sensor insulating layer TINS2, and the cover window CW may be arranged on the polarizing film PF. The descriptions of the polarizing film PF and the cover window CW may refer to the descriptions of FIG. 8 and FIG. 9.

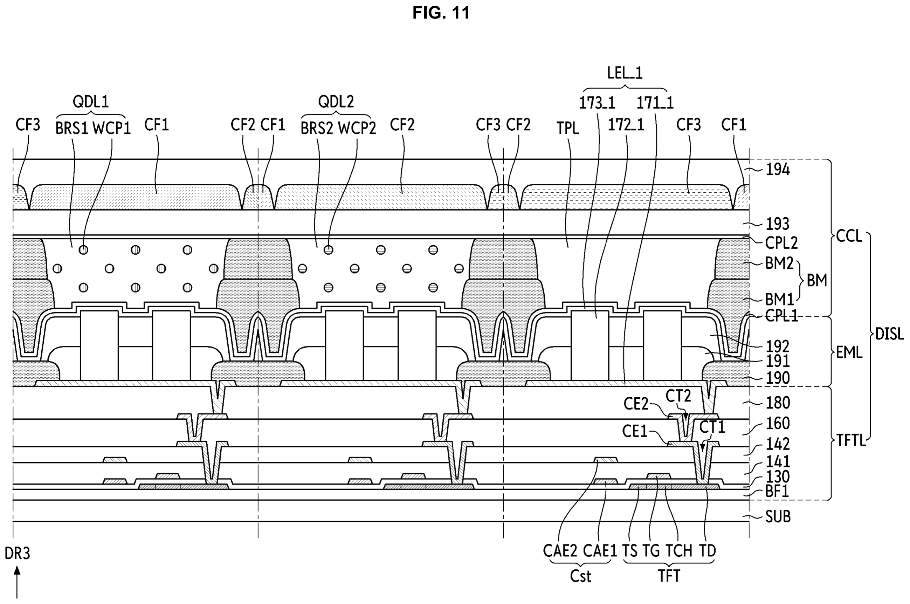

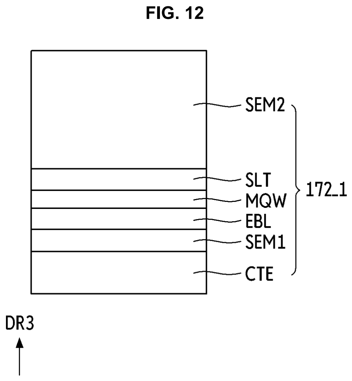

FIG. 11 is a cross-sectional view of an example of the display area of the display module 10 illustrated in FIGS. 8 and 9 according to one or more embodiments of the present invention. FIG. 12 is a detailed cross-sectional view of an example of a light emitting diode element of FIG. 11 according to one or more embodiments.

Referring to FIG. 11 and FIG. 12, a display panel 100 according to one or more embodiments may be a light emitting diode display panel including light emitting elements LEL_1 which include light emitting diode elements 172_1 extending in the third direction DR3. Each of the light emitting diode elements 172_1 may be a micro-light emitting diode having a length or a size in micrometers and made of an inorganic material. In this regard, the display panel 100 according to one or more embodiments may be a micro-light emitting diode display panel.

Because the display panel 100 according to one or more embodiments includes the light emitting diode elements 172_1 made of an inorganic material, an encapsulation structure is not desired or required. Therefore, the display panel 100 according to one or more embodiments may not include (e.g., may exclude) an encapsulation layer ENC.

In addition, if (e.g., when) the light emitting diode elements 172_1 of the display panel 100 according to one or more embodiments emit the same light (e.g., light with a same color), a color control layer CCL may be included. If (e.g., when) the light emitting diode elements 172_1 of the display panel 100 according to one or more embodiments are elements that emit light of a plurality of colors, the color control layer CCL may not be provided.

Furthermore, in FIG. 11, a polarizing film PF and a cover window CW are not illustrated for ease of description. The polarizing film PF may be arranged on the color control layer CCL, and the cover window CW may be arranged on the polarizing film PF.

A display layer DISL of the display panel 100 according to one or more embodiments includes a thin-film transistor layer TFTL, a light emitting element layer EML, and the color control layer CCL. Because the thin-film transistor layer TFTL illustrated in FIG. 11 is substantially the same as the thin-film transistor layer TFTL described with reference to FIG. 10, a description of the thin-film transistor layer TFTL is omitted in describing FIG. 11.

The light emitting element layer EML may include the light emitting elements LEL_1, a bank 190, a third organic layer 191, and a fourth organic layer 192.

Each of the light emitting elements LEL_1 may include a pixel electrode 171_1, the light emitting diode elements 172_1, and a common electrode 173_1. Because the pixel electrode 171_1 is substantially the same as the pixel electrode 171 described with reference to FIG. 10, a description of the pixel electrode 171_1 is omitted in describing FIG. 11.

The bank 190 may cover edges of the pixel electrodes 171_1. The bank 190 may be made of an organic layer such as an acryl resin, an epoxy resin, a phenolic resin, a polyamide resin, or a polyimide resin. The bank 190 may include a light-blocking material to prevent light of the light emitting diode elements 172_1 of any one subpixel from traveling to a neighboring subpixel. For example, in one or more embodiments, the bank 190 may include an inorganic black pigment such as carbon black or an organic black pigment.

A plurality of light emitting diode elements 172_1 may be arranged on each pixel electrode 171_1 exposed without being covered by the bank 190. Each of the light emitting diode elements 172_1 may be a vertical micro-light emitting diode extending in the third direction DR3. In this regard, each of the light emitting diode elements 172_1 may have a rectangular or reverse-tapered cross-sectional shape. However, each of the light emitting diode elements 172_1 is not limited to a vertical micro-light emitting diode, for example, may also be a flip-type (kind) micro-light emitting diode.

Each of the light emitting diode elements 172_1 may be made of an inorganic material such as GaN. Each of the light emitting diode elements 172_1 may have a length of several µm to hundreds of µm in each of the first direction DR1, the second direction DR2, and the third direction DR3. For example, in one or more embodiments, each of the light emitting diode elements 172_1 may have a length of about 100 µm or less in each of the first direction DR1, the second direction DR2, and the third direction DR3.

In one or more embodiments, each of the light emitting diode elements 172_1 may be grown on a semiconductor substrate such as a silicon wafer. Each of the light emitting diode elements 172_1 may be directly transferred from the silicon wafer onto a pixel electrode 171_1 of the substrate SUB. In one or more embodiments, each of the light emitting diode elements 172_1 may be transferred onto a pixel electrode 171_1 of the substrate SUB through an electrostatic method using an electrostatic head or a stamp method using an elastic polymer material such as polydimethylsiloane (PDMS) or silicone as a transfer substrate.

Each of the light emitting diode elements 172_1 may be an inorganic light emitting diode having a length or a size in micrometers and made of an inorganic material. The light emitting diode elements 172_1 may extend in a direction. Each of the light emitting diode elements 172_1 may be shaped like a cylinder, a rod, a wire, or a tube. However, the shape of each of the light emitting diode elements 172_1 is not limited thereto, and each of the light emitting diode elements 172_1 may also have one or more suitable shapes including polygonal prisms, such as a cube, a rectangular parallelepiped or a hexagonal prism, or a shape extending in a direction and having a partially inclined outer surface.

As illustrated in FIG. 12, each of the light emitting diode elements 172_1 may include a contact electrode CTE, a first semiconductor layer SEM1, an electron blocking layer EBL, an active layer MQW, a superlattice layer SLT, and a second semiconductor layer SEM2.

The contact electrode CTE may be arranged on a pixel electrode 171_1. In one or more embodiments, the contact electrode CTE and the pixel electrode 171_1 may be melt-bonded by heat and pressure. In one or more embodiments, the contact electrode CTE and the pixel electrode 171_1 may be bonded to each other through a conductive adhesive member such as an anisotropic conductive film or an anisotropic conductive adhesive. In one or more embodiments, the contact electrode CTE and the pixel electrode 171_1 may be bonded to each other through a soldering process. For example, the contact electrode CTE may include at least any one selected from among gold (Au), copper (Cu), aluminum (Al), and tin (Sn).

The first semiconductor layer SEM1 may be arranged on the contact electrode CTE. The first semiconductor layer SEM1 may be made of GaN doped with a *p* conductivity type (kind) dopant (e.g., P-type dopant) such as magnesium (Mg), zinc (Zn), calcium (Ca), strontium (Sr), or barium (Ba).

The electron blocking layer EBL may be arranged on the first semiconductor layer SEM1. The electron blocking layer EBL may be a layer for suppressing or preventing or reducing too many electrons from flowing into the active layer MQW. For example, the electron blocking layer EBL may be p-AlGaN doped with p-type (kind) Mg. In one or more embodiments, the electron blocking layer EBL may not be provided.

The active layer MQW may be arranged on the electron blocking layer EBL. The active layer MQW may be to emit light through combination of electron-hole pairs according to electrical signals received through the first semiconductor layer SEM1 and the second semiconductor layer SEM2.

The active layer MQW may include a material having a single quantum well structure or a multiple quantum well structure. In one or more embodiments, If (e.g., when) the active layer MQW includes a material having a multiple quantum well structure, it may be a structure in which a plurality of well layers and a plurality of barrier layers are alternately stacked. Here, the well layers may be made of InGaN, and the barrier layers may be made of GaN or AlGaN, but embodiments of the present specification are not limited thereto. In one or more embodiments, the active layer MQW may be a structure in which a semiconductor material having a large band gap energy and a semiconductor material having a small band gap energy are alternately stacked or may include different Group III to V semiconductor materials depending on the wavelength band of light that it emits.

If (e.g., when) the active layer MQW includes InGaN, the color of light that it emits may vary according to indium content (e.g., amount). For example, as the indium content (e.g., amount) increases, the wavelength band of light emitted from the active layer MQW may move to a red wavelength band, and as the indium content (e.g., amount) decreases, the wavelength band of light emitted from the active layer MQW may move to a blue wavelength band. For example, in one or more embodiments, the indium content (e.g., amount) of the active layer MQW of the light emitting diode element 172_1 which emits light in the blue wavelength band may be about 10 wt% to about 20 wt %.

The superlattice layer SLT may be arranged on the active layer MQW. The superlattice layer SLT may be a layer for relieving stress between the second semiconductor layer SEM2 and the active layer MQW. For example, the superlattice layer SLT may be made of InGaN and/or GaN. In one or more embodiments, the superlattice layer SLT may not be provided.

The second semiconductor layer SEM2 may be arranged on the superlattice layer SLT. The second semiconductor layer SEM2 may be doped with n conductivity type (kind) dopant (e.g., N-type dopant) such as Si, Ge, or Sn. For example, in one or more embodiments, the second semiconductor layer SEM2 may be n-GaN doped with n-type (kind) Si.

The third organic layer 191 may be arranged on the pixel electrodes 171_1 not covered by the bank 190 and around the light emitting diode elements 172_1. The third organic layer 191 may cover side surfaces of the bank 190 and partially cover an upper surface of the bank 190. A height of the third organic layer 191 may be greater than a height of the bank 190. The third organic layer 191 may be arranged on a portion of each side surface of each of the light emitting diode elements 172_1. The height of the third organic layer 191 may be smaller than a height of each of the light emitting diode elements 172_1. The third organic layer 191 may be made of an organic layer such as an acryl resin, an epoxy resin, a phenolic resin, a polyamide resin, or a polyimide resin.

The fourth organic layer 192 may be arranged on the third organic layer 191. The fourth organic layer 192 may be arranged on a portion of each side surface of each of the light emitting diode elements 172_1. The sum of the height of the third organic layer 191 and a height of the fourth organic layer 192 may be smaller than the height of each of the light emitting diode elements 172_1. The fourth organic layer 192 may be made of an organic layer such as an acryl resin, an epoxy resin, a phenolic resin, a polyamide resin, or a polyimide resin.

The third organic layer 191 and the fourth organic layer 192 are layers for flattening steps caused by the light emitting diode elements 172_1. If (e.g., when) the height of each of the light emitting diode elements 172_1 is similar to the height of the third organic layer 191, the fourth organic layer 192 may not be provided.

The common electrode 173_1 may be arranged on an upper surface of each of the light emitting diode elements 172_1 and an upper surface of the fourth organic layer 192. The common electrode 173_1 may be arranged on the bank 190 exposed without being covered by the third organic layer 191 and the fourth organic layer 192. The common electrode 173_1 may be a common (e.g., monolithic) layer commonly formed in all subpixels. The common electrode 173_1 may be made of a transparent conductive material (TCO) that can transmit light, such as indium tin oxide (ITO) or indium zinc oxide (IZO).

The color control layer CCL may include a first capping layer CPL1, a light blocking layer BM, a first light conversion layer QDL1, a second light conversion layer QDL2, a light transmission layer TPL, a second capping layer CPL2, a fifth organic layer 193, a plurality of color filters CF1 through CF3, and a sixth organic layer 194.

The first capping layer CPL1 may be arranged on the common electrode 173_1. The first capping layer CPL1 may be made of an inorganic layer, for example, a silicon nitride layer, a silicon oxynitride layer, a silicon oxide layer, a titanium oxide layer, or an aluminum oxide layer.

The light blocking layer BM, the first light conversion layer QDL1, the second light conversion layer QDL2, and the light transmission layer TPL may be arranged on the first capping layer CPL1. The first light conversion layer QDL1, the second light conversion layer QDL2, and the light transmission layer TPL may be separated by the light blocking layer BM. Therefore, the first light conversion layer QDL1 may be arranged on the first capping layer CPL1 in a first subpixel that outputs first light, the second light conversion layer QDL2 may be arranged on the first capping layer CPL1 in a second subpixel that outputs second light, and the light transmission layer TPL may be arranged on the first capping layer CPL1 in a third subpixel that outputs third light. The light blocking layer BM may overlap the bank 190 in the third direction DR3 and may not overlap the light emitting diode elements 172_1.

The first light conversion layer QDL1 may convert a portion of light in a blue wavelength band incident from the light emitting diode elements 172_1 into light in a red wavelength band. The first light conversion layer QDL1 may include a first base resin BRS1 and first wavelength conversion particles WCP1. The first base resin BRS1 may include a light-transmitting organic material. For example, the first base resin BRS1 may include an epoxy resin, an acrylic resin, a cardo resin, or an imide resin. The first wavelength conversion particles WCP1 may convert a portion of light in the blue wavelength band incident from the light emitting diode elements 172_1 into light in the red wavelength band. The first wavelength conversion particles WCP1 may be quantum dots, quantum rods, fluorescent materials, and/or phosphorescent materials.

The second light conversion layer QDL2 may convert a portion of light in the blue wavelength band incident from the light emitting diode elements 172_1 into light in a green wavelength band. The second light conversion layer QDL2 may include a second base resin BRS2 and second wavelength conversion particles WCP2. The second base resin BRS2 may include a light-transmitting organic material. For example, the second base resin BRS2 may include an epoxy resin, an acrylic resin, a cardo resin, or an imide resin. The second wavelength conversion particles WCP2 may convert a portion of light in the blue wavelength band incident from the light emitting diode elements 172_1 into light in the green wavelength band. The second wavelength conversion particles WCP2 may be quantum dots, quantum rods, fluorescent materials, and/or phosphorescent materials.

The light transmission layer TPL may include a light-transmitting organic material. For example, the light transmission layer TPL may include an epoxy resin, an acrylic resin, a cardo resin, or an imide resin.

The light blocking layer BM may include a first light blocking layer BM1 and a second light blocking layer BM2 stacked sequentially in the third direction DR3. A length of the first light blocking layer BM1 in the first direction DR1 or a length of the first light blocking layer BM1 in the second direction DR2 may be greater than a length of the second light blocking layer BM2 in the first direction DR1 or a length of the second light blocking layer BM2 in the second direction DR2. The first light blocking layer BM1 and the second light blocking layer BM2 may each be made of an organic layer such as an acryl resin, an epoxy resin, a phenolic resin, a polyamide resin, or a polyimide. The first light blocking layer BM1 and the second light blocking layer BM2 may each include a light blocking material to prevent light of the light emitting diode elements 172_1 of any one subpixel from traveling to a neighboring subpixel. For example, in one or more embodiments, the first light blocking layer BM1 and the second light blocking layer BM2 may each include an inorganic black pigment such as carbon black and/or an organic black pigment.

The second capping layer CPL2 may be arranged on the light blocking layer BM, the first light conversion layer QDL1, the second light conversion layer QDL2, and the light transmission layer TPL. The second capping layer CPL2 may be made of an inorganic layer, for example, a silicon nitride layer, a silicon oxynitride layer, a silicon oxide layer, a titanium oxide layer, or an aluminum oxide layer. The light blocking layer BM, the first light conversion layer QDL1, the second light conversion layer QDL2, and the light transmission layer TPL may be encapsulated by the first capping layer CPL1 and the second capping layer CPL2.

The fifth organic layer 193 may be arranged on the second capping layer CPL2. The fifth organic layer 193 may be made of an acryl resin, an epoxy resin, a phenolic resin, a polyamide resin, or a polyimide resin.

A plurality of color filters CF1 through CF3 may be arranged on the fifth organic layer 193. The color filters CF1 through CF3 may include first color filters CF1, second color filters CF2, and third color filters CF3.

A first color filter CF1 arranged in the first subpixel may be to transmit light in the red wavelength band and absorb or block light in the blue wavelength band. Therefore, the first color filter CF1 may be to transmit light in the red wavelength band into which light in the blue wavelength band has been converted by the first light conversion layer QDL1 among light in the blue wavelength band emitted from the light emitting diode elements 172_1 and may be to absorb or block light in the blue wavelength band which has not been converted by the first light conversion layer QDL1. Accordingly, the first subpixel may be to emit light in the red wavelength band.

A second color filter CF2 arranged in the second subpixel may be to transmit light in the green wavelength band and absorb or block light in the blue wavelength band. Therefore, the second color filter CF2 may be to transmit light in the green wavelength band into which light in the blue wavelength band has been converted by the second light conversion layer QDL2 among light in the blue wavelength band emitted from the light emitting diode elements 172_1 and may be to absorb or block light in the blue wavelength band which has not been converted by the second light conversion layer QDL2. Accordingly, the second subpixel may be to emit light in the green wavelength band.

A third color filter CF3 arranged in the third subpixel may be to transmit light in the blue wavelength band. Therefore, the third color filter CF3 may be to transmit light in the blue wavelength band passing through the light transmission layer TPL after being emitted from the light emitting diode elements 172_1. Accordingly, the third subpixel may be to emit light in the blue wavelength band.

The sixth organic layer 194 for planarization may be arranged on the color filters CF1 through CF3. The sixth organic layer 194 may be made of an acryl resin, an epoxy resin, a phenolic resin, a polyamide resin, or a polyimide resin.

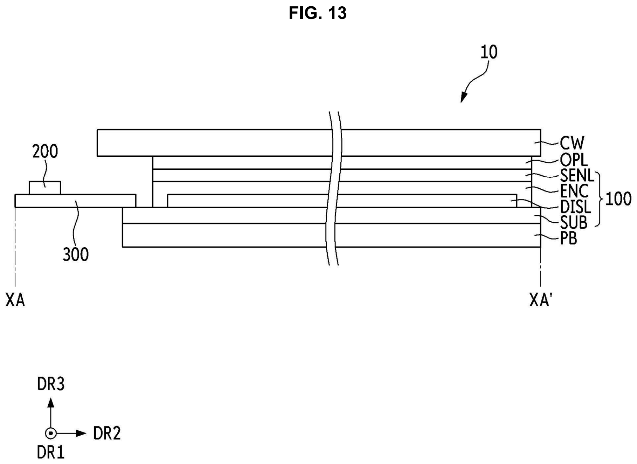

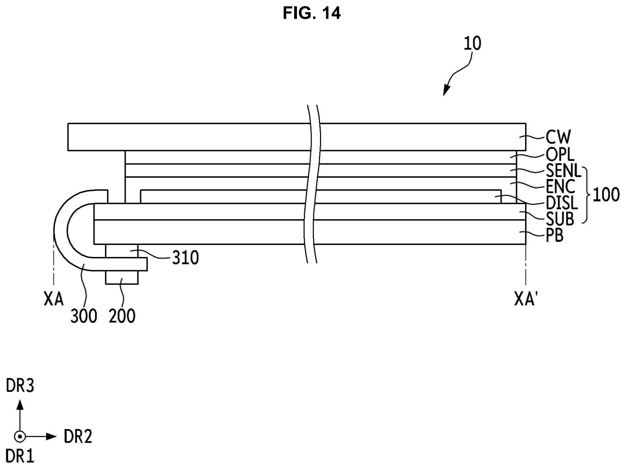

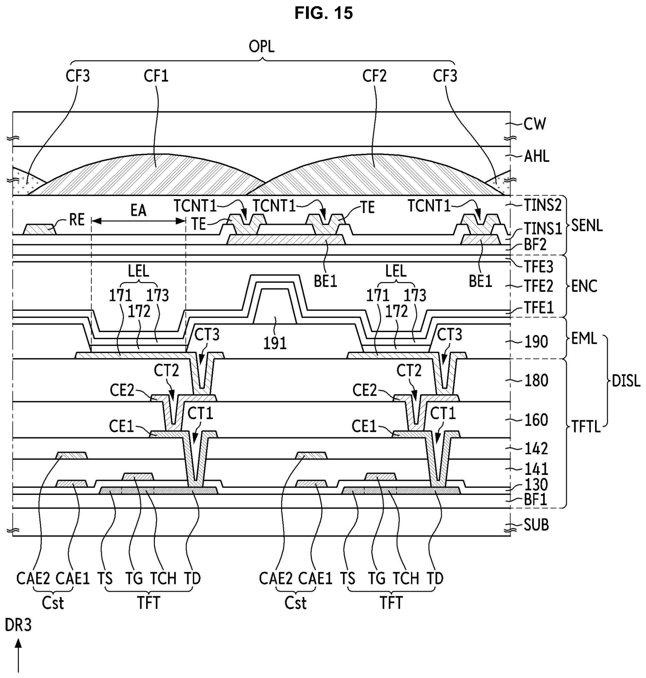

FIGS. 13 and 14 are side views of a display module according to one or more embodiments of the present invention. FIG. 15 is a cross-sectional view of an example of a display area of the display module illustrated in FIGS. 13 and 14 according to one or more embodiments.

The embodiment of FIGS. 13 through 15 is different from the embodiment of FIGS. 8 through 10 in that an optical layer OPL is arranged instead of a polarizing film PF. The optical layer OPL may include a plurality of color filters CF1 through CF3 to prevent or reduce external light from being reflected from the display panel 100, and thus improving the visibility of an image displayed on a display panel 100. In one or more embodiments, a planarization layer and/or an adhesive layer AHL may be arranged between the optical layer OPL and a cover window CW.

Although the optical layer OPL is arranged on a sensor electrode layer SENL of the display panel 100 in FIGS. 13 through 15, embodiments of the present specification are not limited thereto. For example, in one or more embodiments, the optical layer OPL may also be arranged between an encapsulation layer ENC and the sensor electrode layer SENL.

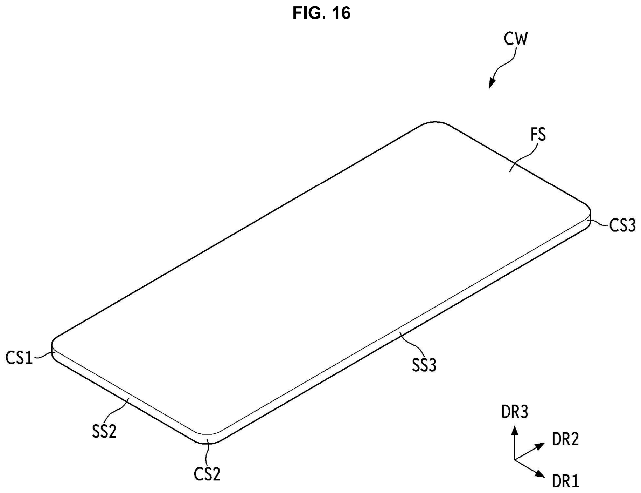

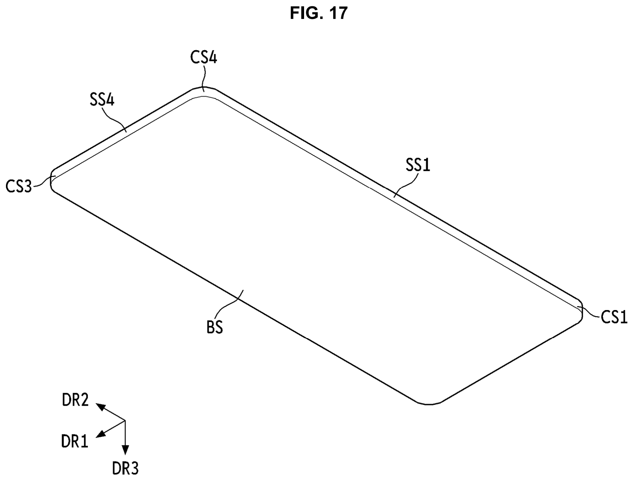

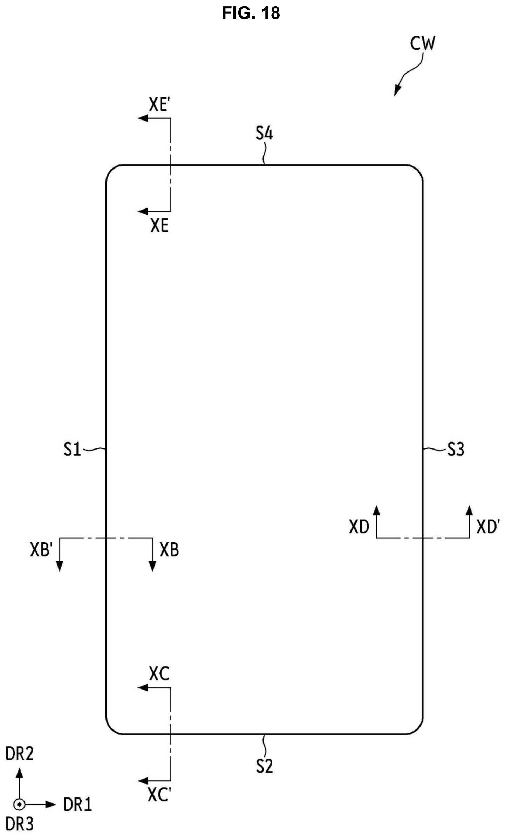

FIGS. 16 and 17 are perspective views of a cover window CW according to one or more embodiments of the present invention. FIG. 18 is a plan view of the cover window CW according to one or more embodiments.

Referring to FIGS. 16 through 18, the cover window CW includes a front surface FS, a back surface BS, first through fourth side surfaces SS1 through SS4, and first through fourth corner surfaces CS1 through CS4.

The front surface FS may have short sides in the first direction DR1 and long sides in the second direction DR2. Each corner of the front surface FS where a short side in the first direction DR1 meets a long side in the second direction DR2 may be rounded to have a selected radius of curvature or may be right-angled. The front surface FS may be formed flat or may include a curved portion having a selected radius of curvature.

The first side surface SS1 may extend from a first border or edge, termed as "first side S1" in the following, of the front surface FS, and the first side S1 of the front surface FS may be a left side of the front surface FS. The second side surface SS2 may extend from a second border or edge, termed as "second side S2" in the following, of the front surface FS, and the second side S2 of the front surface FS may be a lower side of the front surface FS. The third side surface SS3 may extend from a third border or edge, termed as "third side S3" inf the following, of the front surface FS, and the third side S3 of the front surface FS may be a right side of the front surface FS. The fourth side surface SS4 may extend from a fourth border or edge, termed as "fourth side S4" in the following, of the front surface FS, and the fourth side S4 of the front surface FS may be an upper side of the front surface FS.

The first corner surface CS1 may be a corner side surface arranged between the first side surface SS1 and the second side surface SS2. The second corner surface CS2 may be a corner side surface arranged between the second side surface SS2 and the third side surface SS3. The third corner surface CS3 may be a corner side surface arranged between the third side surface SS3 and the fourth side surface SS4. The fourth corner surface CS4 may be a corner side surface arranged between the first side surface SS1 and the fourth side surface SS4 (i.e., between the fourth side surface SS4 and the first side surface SS1).

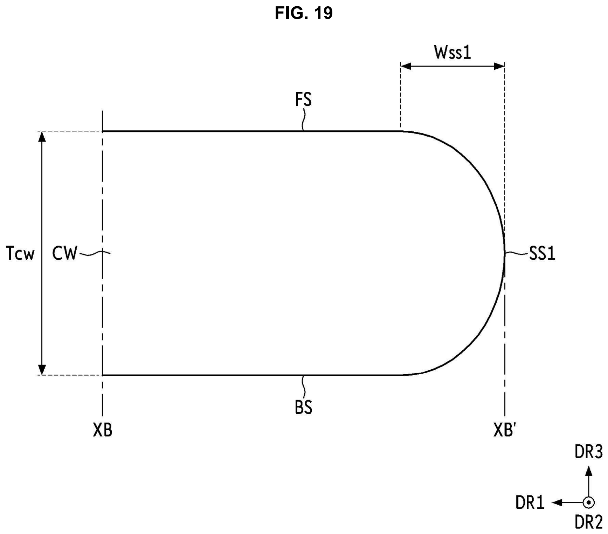

FIGS. 19 through 22 are cross-sectional views of the first through fourth side surfaces SS1 through SS4 of the cover window CW according to one or more embodiments of the present invention.

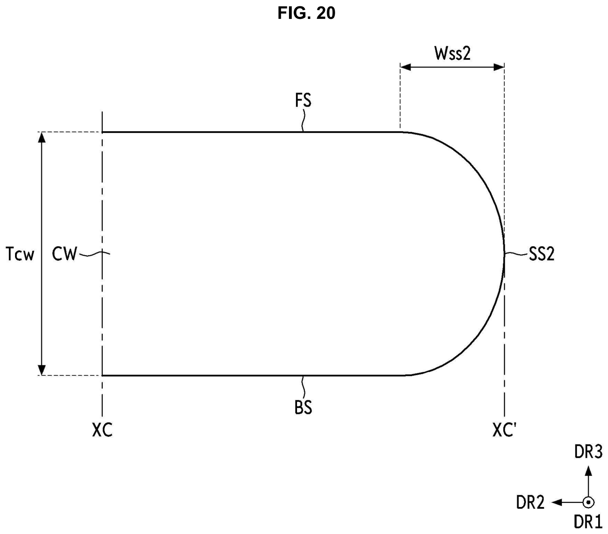

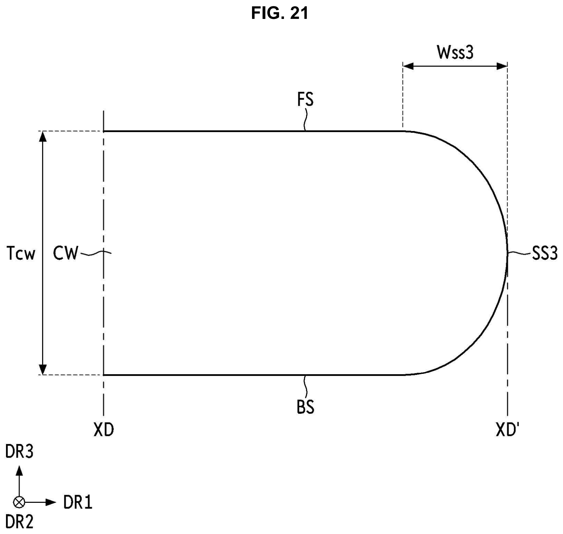

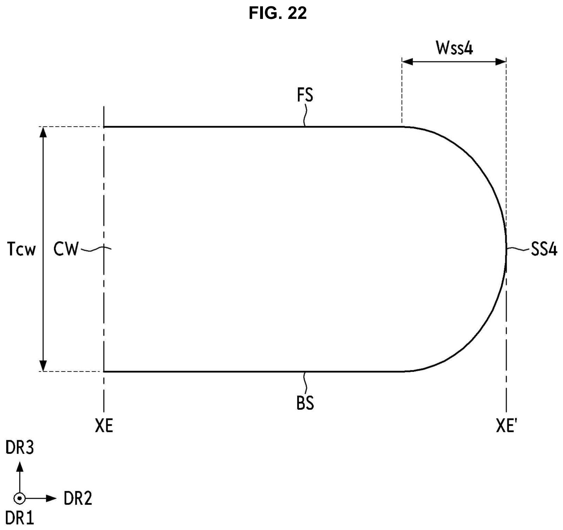

FIG. 19 illustrates an example of a cross section of the first side surface SS1 of the cover window CW taken along the line XB-XB' of FIG. 18 according to one or more embodiments. FIG. 20 illustrates an example of a cross section of the second side surface SS2 of the cover window CW taken along the line XC-XC' of FIG. 18 according to one or more embodiments. FIG. 21 illustrates an example of a cross section of the third side surface SS3 of the cover window CW taken along the line XD-XD' of FIG. 18 according to one or more embodiments. FIG. 22 illustrates an example of a cross section of the fourth side surface SS4 of the cover window CW taken along the line XE-XE' of FIG. 18 according to one or more embodiments.

Referring to FIGS. 19 through 22, each of the first side surface SS1, the second side surface SS2, the third side surface SS3, and the fourth side surface SS4 of the cover window CW may have a curved shape having a selected radius of curvature. The radius of curvature of each of the first side surface SS1, the second side surface SS2, the third side surface SS3, and the fourth side surface SS4 of the cover window CW may be about 15 µm to about 25 µm. If (e.g., when) the radius of curvature of each of the first side surface SS1, the second side surface SS2, the third side surface SS3, and the fourth side surface SS4 of the cover window CW is less than about 15 µm or greater than about 25 µm, the impact strength of each of the first side surface SS1, the second side surface SS2, the third side surface SS3, and the fourth side surface SS4 may be reduced.

A difference between the radius of curvature of the first side surface SS1, the radius of curvature of the second side surface SS2, the radius of curvature of the third side surface SS3, and the radius of curvature of the fourth side surface SS4 of the cover window CW may be about 2.5 µm or less, for example, the difference between any two selected from among the radius of curvature of the first side surface SS1, the radius of curvature of the second side surface SS2, the radius of curvature of the third side surface SS3, and the radius of curvature of the fourth side surface SS4 of the cover window CW may be about 2.5 µm or less, but embodiments of the present specification are not limited thereto. For example, the difference between the radius of curvature of any two side surfaces (SS1, SS2, SS3, SS4) of the cover window (CW) may be about 2.5 µm or less. This applies to the first, second, third, and fourth side surfaces, but the specification is not limited to this range.

A width Wss1 (length in the first direction DR1 between the first side S1 and the apex of the first side surface SS1) of the first side surface SS1 of the cover window CW, a width Wss2 (length in the second direction DR2 between the second side S2 and the apex of the second side surface SS2) of the second side surface SS2, a width Wss3 (length in the first direction DR1 between the third side S3 and the apex of the third side surface SS3) of the third side surface SS3, and a width Wss4 (length in the second direction DR2 between the fourth side S4 and the apex of the fourth side surface SS4) of the fourth side surface SS4 may be about 10 µm to about 20 µm. In addition, a thickness Tcw of the cover window CW may be about 30 µm to about 60 µm.

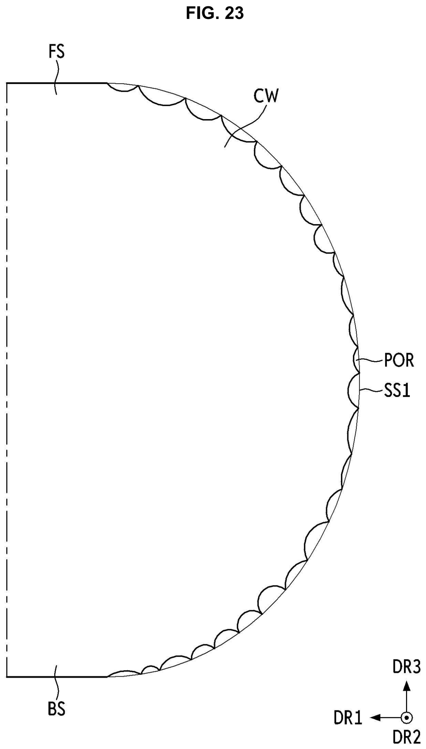

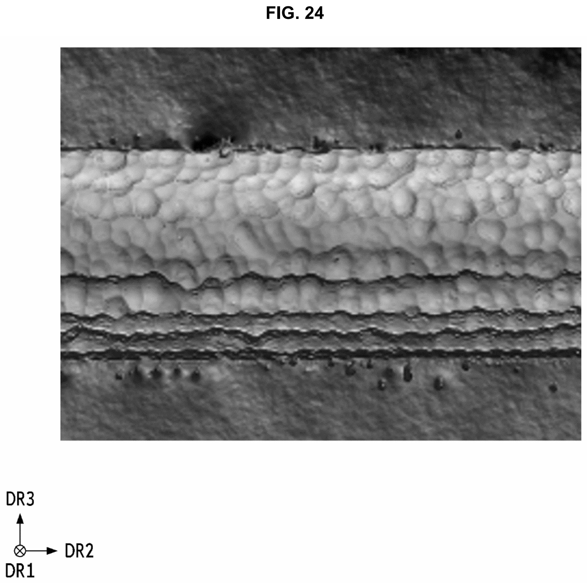

FIG. 23 is a detailed cross-sectional view of the first side surface SS1 of the cover window CW of FIG. 19 according to one or more embodiments. FIG. 24 is a detailed three-dimensional (3D) image of the first side surface SS1 of the cover window CW of FIG. 19 according to one or more embodiments.

Referring to FIG. 23 and FIG. 24, the first side surface SS1 of the cover window CW may include a plurality of etch pores POR. Each of the second side surface SS2, the third side surface SS3, and the fourth side surface SS4 of the cover window CW may also include a plurality of etch pores POR.

After a plurality of laser spots are formed on the cover window CW, the cover window CW may be etched using an etchant. Accordingly, each of the first side surface SS1, the second side surface SS2, the third side surface SS3, and the fourth side surface SS4 of the cover window CW may be formed into a curved shape having a selected radius of curvature. Here, the etch pores POR may be traces left in the process of etching the laser spots using the etchant. In the present invention, the term "etch pore" may refer to a dimple structure formed by an etching process on a side surface of the cover window. For example, the etch pores POR are traces left from etching the laser spots, referring to dimple structures formed on the side surfaces during the etching process.

The etch pores POR may have an irregular shape similar to a circle or an ellipse. The etch pores POR may be formed in the entire area of each of the first side surface SS1, the second side surface SS2, the third side surface SS3, and the fourth side surface SS4 of the cover window CW.

The roughness of the etch pores POR of the first side surface SS1 may be defined as a difference between a maximum height and a minimum height of the etch pores POR overlapping each other in the second direction DR2 in which the first side surface SS1 extends. The difference between the maximum height and the minimum height of the etch pores POR of the first side surface SS1 which overlap each other in the second direction DR2 may be about 0.1 µm to about 0.5 µm.

The roughness of the etch pores POR of the second side surface SS2 may be a difference between a maximum height and a minimum height of the etch pores POR of the second side surface SS2 which overlap each other in the first direction DR1 in which the second side surface SS2 extends and may be about 0.1 µm to about 0.5 µm. In addition, the roughness of the etch pores POR of the third side surface SS3 may be a difference between a maximum height and a minimum height of the etch pores POR of the third side surface SS3 which overlap each other in the second direction DR2 in which the third side surface SS3 extends and may be about 0.1 µm to about 0.5 µm. In addition, the roughness of the etch pores POR of the fourth side surface SS4 may be a difference between a maximum height and a minimum height of the etch pores POR of the fourth side surface SS4 which overlap each other in the first direction DR1 in which the fourth side surface SS4 extends and may be about 0.1 µm to about 0.5 µm.

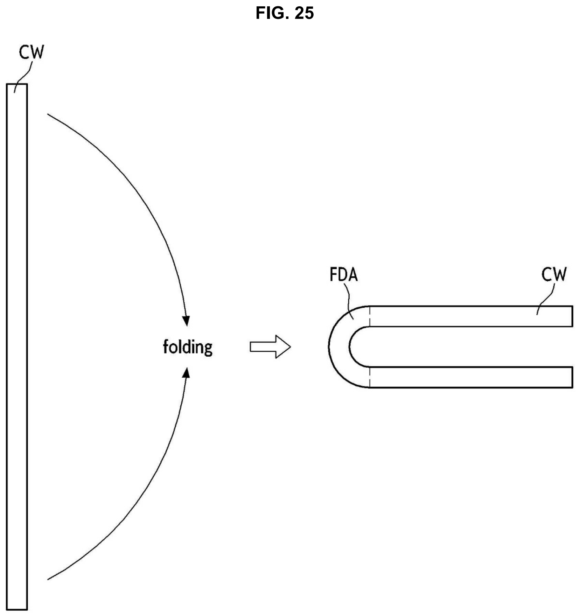

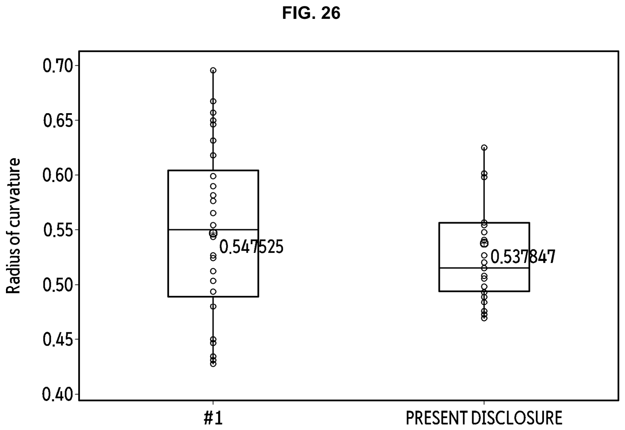

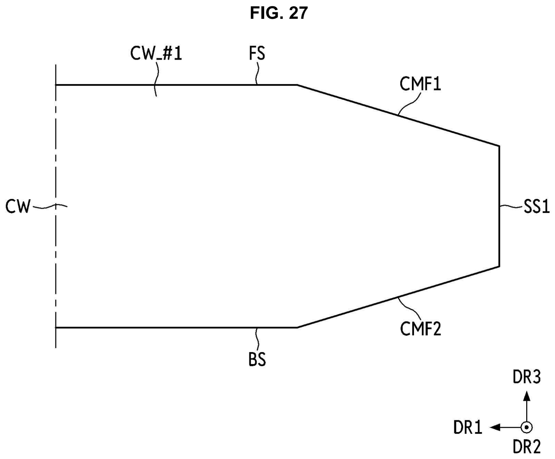

FIG. 25 is an illustrative drawing for explaining the flexural strength of a cover window CW. FIG. 26 is a graph illustrating an example of the flexural strength of cover windows CW according to one or more embodiments of the present invention. FIG. 27 is a cross-sectional view of an example of a first side surface SS1 of a cover window CW_#1 of a first sample according to one or more embodiments of the present invention.

Referring to FIG. 25, the flexural strength of the cover window CW refers to a minimum radius of curvature of a folding area FDA of the cover window CW at which the cover window CW is not broken when the cover window CW is bent.

Referring to FIG. 26 and FIG. 27, the cover window CW_#1 of the first sample may be formed to include a first chamfered surface CMF1 between a front surface FS and a first side surface SS1 and a second chamfered surface CMF2 between a back surface BS and the first side surface SS1 as illustrated in FIG. 27 by processing a side surface of a cover window CW using a computer numerical control (CNC) grinder. The first chamfered surface CMF1 may be an inclined surface connecting the front surface FS and the first side surface SS1, and the second chamfered surface CMF2 may be an inclined surface connecting the back surface BS and the first side surface SS1. For example, the cover window CW_#1 of the first sample may be formed to include the first chamfer surface CMF1 and the second chamfer surface CMF2 processed using the CNC grinder rather than being formed such that a cross section of the first side surface SS1 has a selected radius of curvature.

In FIG. 26, the X-axis indicates the cover window CW_#1 of the first sample and the cover window CW according to one or more embodiments of the present invention ("present disclosure"), and the Y-axis indicates the radius of curvature in µm (also termed as "R") as the flexural strength of a cover window. An average value of the flexural strength of the cover window CW according to one or more embodiments may be about 0.53 µm. An average value of the flexural strength of the cover window CW_#1 of the first sample may be about 0.54 µm. The average value of the flexural strength of the cover window CW according to one or more embodiments may be smaller than the average value of the flexural strength of the cover window CW_#1 of the first sample. Therefore, it can be seen that the folding characteristics of the cover window CW according to one or more embodiments are better than the folding characteristics of the cover window CW_#1 of the first sample.

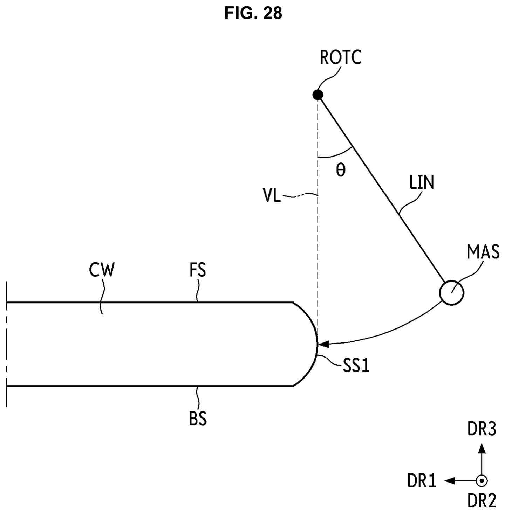

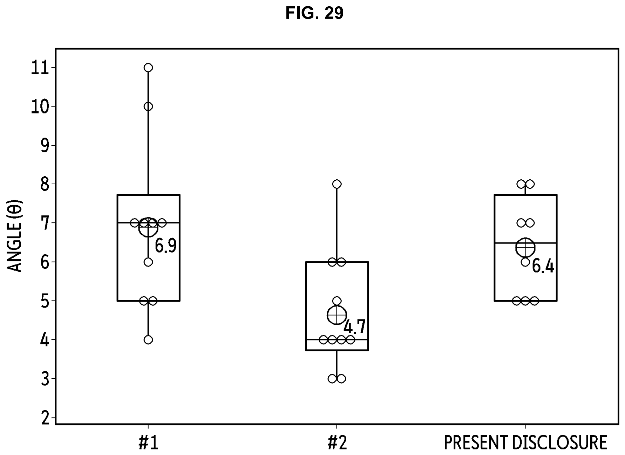

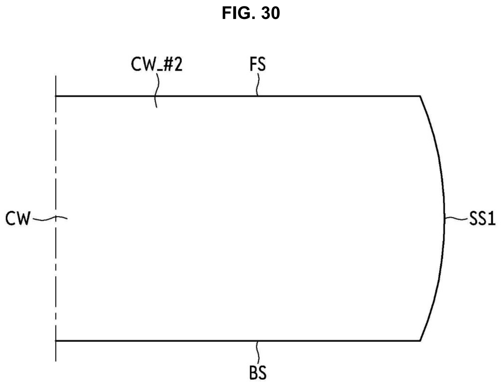

FIG. 28 is an illustrative drawing for explaining a Charpy impact test of a cover window. FIG. 29 is a graph illustrating an example of the Charpy impact test of cover windows according to one or more embodiments of the present invention ("present disclosure"). FIG. 30 is a cross-sectional view of an example of a first side surface SS1 of a cover window CW_#2 of a second sample according to one or more embodiments of the present invention.

Referring to FIG. 28, the Charpy impact test is a test that applies an impact load to a first side surface SS1 of a cover window CW using a pendulum bob MAS and calculates an impact angle θ of the pendulum bob MAS as an impact value when the first side surface SS1 of the cover window CW is fractured.

The pendulum bob MAS may be connected to a pivot ROTC by a string LIN. The pivot ROTC of the pendulum bob MAS may overlap the first side surface SS1 in the third direction DR3. The impact angle θ of the pendulum bob MAS refers to an angle by which the pendulum bob MAS is lifted from a virtual line VL connecting the pivot ROTC of the pendulum bob MAS and the first side surface SS1 in the third direction DR3.

Referring to FIG. 29 and FIG. 30, the cover window CW_#1 of the first sample has already been described above with reference to FIG. 27. The cover window CW_#2 of the second sample may include the first side surface SS1 having a very large radius of curvature. For example, the radius of curvature of the first side surface SS1 of the cover window CW_#2 of the second sample may be about 150 µm.

In FIG. 29, the X-axis indicates the cover window CW_#1 of the first sample, the cover window CW_#2 of the second sample and the cover window CW according to one or more embodiments of the present invention, and the Y-axis indicates the Charpy impact angle θ. An average value of the impact angle θ of the first side surface SS1 of the cover window CW according to one or more embodiments may be about 6.4 degrees. An average value of the impact angle θ of the first side surface SS1 of the cover window CW_#1 of the first sample may be about 6.9 degrees. An average value of the impact angle θ of the first side surface SS1 of the cover window CW_#2 of the second sample may be about 4.7 degrees.

As is apparent from the above description, the impact angle θ of the first side surface SS1 of the cover window CW according to one or more embodiments may be greater than the impact angle θ of the first side surface SS1 of the cover window CW_#2 of the second sample and may be similar to the average value of the impact angle θ of the first side surface SS1 of the cover window CW_#1 of the first sample. Therefore, a reduction in the mechanical strength of the cover window CW according to one or more embodiments may be minimized or reduced.

In summary, if (e.g., when) the first side surface SS1 of the cover window CW according to one or more embodiments has a radius of curvature of about 15 µm to about 25 µm, it has a shape that is easier to absorb impact than the first side surface SS1 of the cover window CW_#2 of the second sample. Therefore, the mechanical strength, such as side strength, of the first side surface SS1 of the cover window CW according to one or more embodiments may be maintained at a high level.

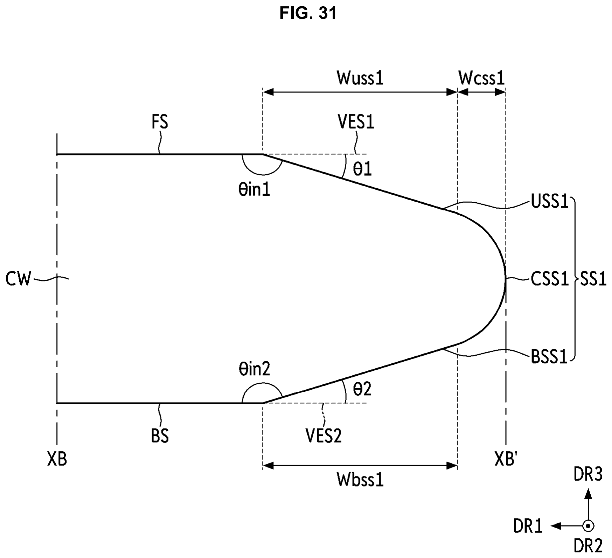

FIGS. 31 through 34 are side views of first through fourth side surfaces SS1 through SS4 of a cover window CW according to one or more embodiments of present invention.

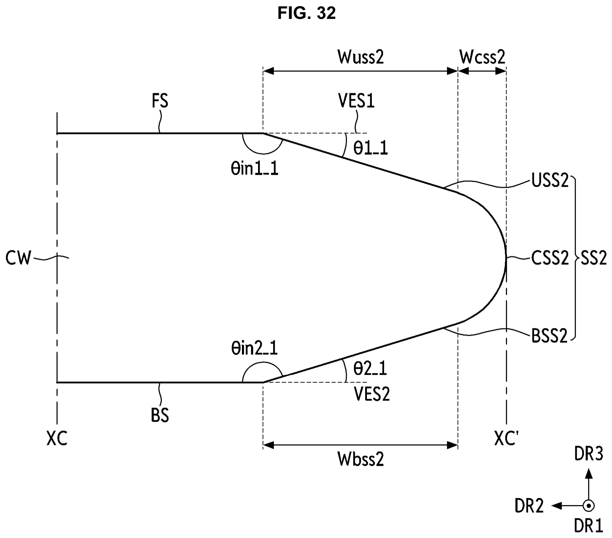

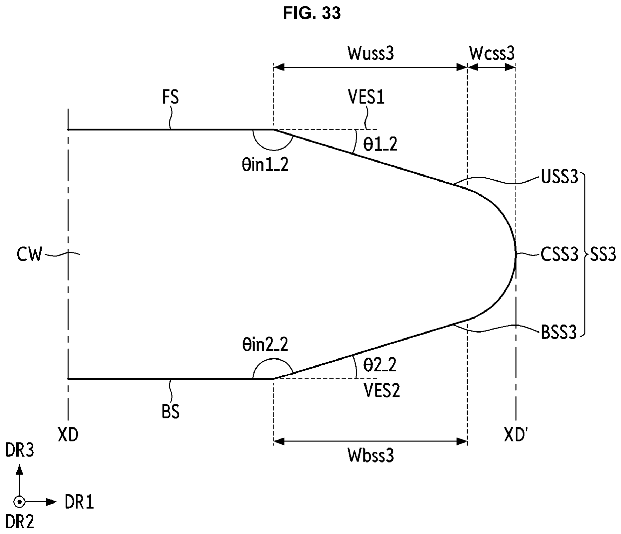

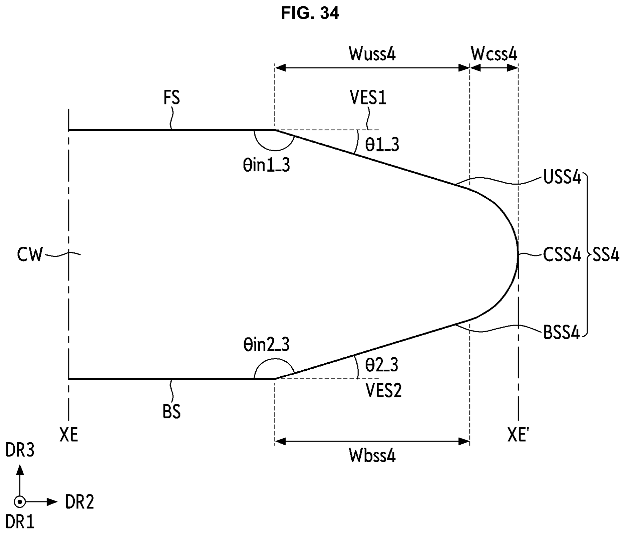

FIG. 31 illustrates an example of a cross section of the first side surface SS1 of the cover window CW taken along the line XB-XB' of FIG. 18 according to one or more embodiments. FIG. 32 illustrates an example of a cross section of the second side surface SS2 of the cover window CW taken along the line XC-XC' of FIG. 18 according to one or more embodiments. FIG. 33 illustrates an example of a cross section of the third side surface SS3 of the cover window CW taken along the line XD-XD' of FIG. 18 according to one or more embodiments. FIG. 34 illustrates an example of a cross section of the fourth side surface SS4 of the cover window CW taken along the line XE-XE' of FIG. 18 according to one or more embodiments.

Referring to FIG. 31, in one or more embodiments, the first side surface SS1 of the cover window CW includes a first central side surface CSS1, a first upper side surface USS1 arranged between a front surface FS and the first central side surface CSS1, and a first lower side surface BSS1 arranged between a back surface BS and the first central side surface CSS1. While the first central side surface CSS1 is curved, the first upper side surface USS1 and the first lower side surface BSS1 may each be flat, but embodiments of the present invention are not limited thereto.

The first central side surface CSS1 may be a curved surface having a selected radius of curvature. The radius of curvature of the first central side surface CSS1 may be about 7 µm to about 13 µm. If (e.g., when) the radius of curvature of the first central side surface CSS1 is less than about 7 µm or greater than about 13 µm, the impact strength of the first central side surface CSS1 may be reduced. A width Wcss1 (length in the first direction DR1) of the first central side surface CSS1 may be about 3 µm to about 5 µm.

The first upper side surface USS1 may be an inclined surface that forms a first angle θ1 with a virtual first extension surface VES1 extending from the front surface FS. A first internal angle θin1 formed by the front surface FS and the first upper side surface USS1 may be an obtuse angle. A width Wuss1 (length in the first direction DR1) of the first upper side surface USS1 may be greater than the width Wcss1 of the first central side surface CSS1. For example, in one or more embodiments, the width Wuss1 of the first upper side surface USS1 may be about 20 µm to about 40 µm.

The first lower side surface BSS1 may be an inclined surface that forms a second angle θ2 with a virtual second extension surface VES2 extending from the back surface BS. A second internal angle θin2 formed by the back surface BS and the first lower side surface BSS1 may be an obtuse angle. A width Wbss1 (length in the first direction DR1) of the first lower side surface BSS1 may be greater than the width Wcss1 of the first central side surface CSS1. For example, in one or more embodiments, the width Wbss1 of the first lower side surface BSS1 may be about 20 µm to about 40 µm.

Referring to FIG. 32, in one or more embodiments, the second side surface SS2 of the cover window CW includes a second central side surface CSS2, a second upper side surface USS2 arranged between the front surface FS and the second central side surface CSS2, and a second lower side surface BSS2 arranged between the back surface BS and the second central side surface CSS2. While the second central side surface CSS2 is curved, the second upper side surface USS2 and the second lower side surface BSS2 may each be flat, but embodiments of the present invention are not limited thereto.

The second central side surface CSS2 may have a curved shape having a selected radius of curvature. The radius of curvature of the second central side surface CSS2 may be about 7 µm to about 13 µm. If (e.g., when) the radius of curvature of the second central side surface CSS2 is less than about 7 µm or greater than about 13 µm, the impact strength of the second central side surface CSS2 may be reduced. A width Wcss2 (length in the second direction DR2) of the second central side surface CSS2 may be about 3 µm to about 5 µm.

The second upper side surface USS2 may be an inclined surface that forms a first angle θ1_1 with the virtual first extension surface VES1 extending from the front surface FS. A first internal angle θin1_1 formed by the front surface FS and the second upper side surface USS2 may be an obtuse angle. A width Wuss2 (length in the second direction DR2) of the second upper side surface USS2 may be greater than the width Wcss2 of the second central side surface CSS2. For example, in one or more embodiments, the width Wuss2 of the second upper side surface USS2 may be about 20 µm to about 40 µm.

The second lower side surface BSS2 may be an inclined surface that forms a second angle θ2_1 with the virtual second extension surface VES2 extending from the back surface BS. A second internal angle θin2_1 formed by the back surface BS and the second lower side surface BSS2 may be an obtuse angle. A width Wbss2 (length in the second direction DR2) of the second lower side surface BSS2 may be greater than the width Wcss2 of the second central side surface CSS2. For example, in one or more embodiments, the width Wbss2 of the second lower side surface BSS2 may be about 20 to 40 µm.

Referring to FIG. 33, in one or more embodiments, the third side surface SS3 of the cover window CW includes a third central side surface CSS3, a third upper side surface USS3 arranged between the front surface FS and the third central side surface CSS3, and a third lower side surface BSS3 arranged between the back surface BS and the third central side surface CSS3. While the third central side surface CSS3 is curved, the third upper side surface USS3 and the third lower side surface BSS3 may each be flat, but embodiments of the present specification are not limited thereto.

The third central side surface CSS3 may have a curved shape having a selected radius of curvature. The radius of curvature of the third central side surface CSS3 may be about 7 µm to about 13 µm. If (e.g., when) the radius of curvature of the third central side surface CSS3 is less than about 7 µm or greater than about 13 µm, the impact strength of the third central side surface CSS3 may be reduced. A width Wcss3 (length in the first direction DR1) of the third central side surface CSS3 may be about 3 µm to about 5 µm.

The third upper side surface USS3 may be an inclined surface that forms a first angle θ1_2 with the virtual first extension surface VES1 extending from the front surface FS. A first internal angle θin1_2 formed by the front surface FS and the third upper side surface USS3 may be an obtuse angle. A width Wuss3 (length in the first direction DR1) of the third upper side surface USS3 may be greater than the width Wcss3 of the third central side surface CSS3. For example, in one or more embodiments, the width Wuss3 of the third upper side surface USS3 may be about 20 µm to about 40 µm.

The third lower side surface BSS3 may be an inclined surface that forms a second angle θ2_2 with the virtual second extension surface VES2 extending from the back surface BS. A second internal angle θin2_2 formed by the back surface BS and the third lower side surface BSS3 may be an obtuse angle. A width Wbss3 (length in the first direction DR1) of the third lower side surface BSS3 may be greater than the width Wcss3 of the third central side surface CSS3. For example, in one or more embodiments, the width Wbss3 of the third lower side surface BSS3 may be about 20 µm to about 40 µm.

Referring to FIG. 34, in one or more embodiments, the fourth side surface SS4 of the cover window CW includes a fourth central side surface CSS4, a fourth upper side surface USS4 arranged between the front surface FS and the fourth central side surface CSS4, and a fourth lower side surface BSS4 arranged between the back surface BS and the fourth central side surface CSS4. While the fourth central side surface CSS4 is curved, the fourth upper side surface USS4 and the fourth lower side surface BSS4 may each be flat, but embodiments of the present invention are not limited thereto.

The fourth central side surface CSS4 may have a curved shape having a selected radius of curvature. The radius of curvature of the fourth central side surface CSS4 may be about 7 µm to about 13 µm. If (e.g., when) the radius of curvature of the fourth central side surface CSS4 is less than about 7 µm or greater than about 13 µm, the impact strength of the first central side surface CSS1 may be reduced. A width Wcss4 (length in the second direction DR2) of the fourth central side surface CSS4 may be about 3 µm to about 5 µm.

The fourth upper side surface USS4 may be an inclined surface that forms a first angle θ1_3 with the virtual first extension surface VES1 extending from the front surface FS. A first internal angle θin1_3 formed by the front surface FS and the fourth upper side surface USS4 may be an obtuse angle. A width Wuss4 (length in the second direction DR2) of the fourth upper side surface USS4 may be greater than the width Wcss4 of the fourth central side surface CSS4. For example, in one or more embodiments, the width Wuss4 of the fourth upper side surface USS4 may be about 20 µm to about 40 µm.

The fourth lower side surface BSS4 may be an inclined surface that forms a second angle θ2_3 with the virtual second extension surface VES2 extending from the back surface BS. A second internal angle θin2_3 formed by the back surface BS and the fourth lower side surface BSS4 may be an obtuse angle. A width Wbss4 (length in the second direction DR2) of the fourth lower side surface BSS4 may be greater than the width Wcss4 of the fourth central side surface CSS4. For example, in one or more embodiments, the width Wbss4 of the fourth lower side surface BSS4 may be about 20 µm to about 40 µm.

A difference between the radius of curvature of the first central side surface CSS1, the radius of curvature of the second central side surface CSS2, the radius of curvature of the third central side surface CSS3, and the radius of curvature of the fourth central side surface CSS4 may be about 2.5 µm or less. For example, the difference between any two selected from among the radius of curvature of the first central side surface CSS1, the radius of curvature of the second central side surface CSS2, the radius of curvature of the third central side surface CSS3, and the radius of curvature of the fourth central side surface CSS4 may be about 2.5 µm or less. To put it another way, the difference between the radius of curvature of any two central side surfaces (CSS1, CSS2, CSS3, CSS4) of the cover window may be about 2.5 µm or less. This applies to the first, second, third, and fourth central side surfaces.

As illustrated in FIGS. 31 through 34, when each of the first central side surface CSS1, the second central side surface CSS2, the third central side surface CSS3, and the fourth central side surface CSS4 of the cover window CW according to one or more embodiments has a radius of curvature of about 7 µm to about 13 µm, it has a shape that is easier to absorb impact than the first side surface SS1 of the cover window CW_#2 of the second sample illustrated in FIG. 30. Therefore, the mechanical strength, such as side strength, of the first side surface SS1 of the cover window CW according to one or more embodiments may be maintained at a high level.

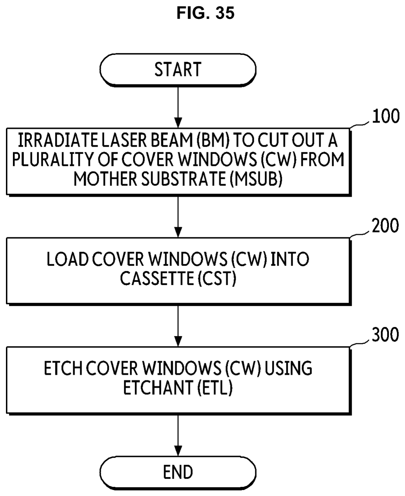

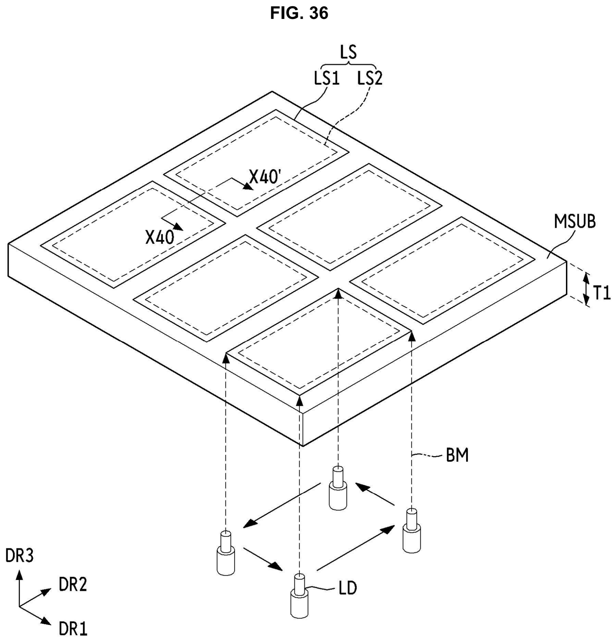

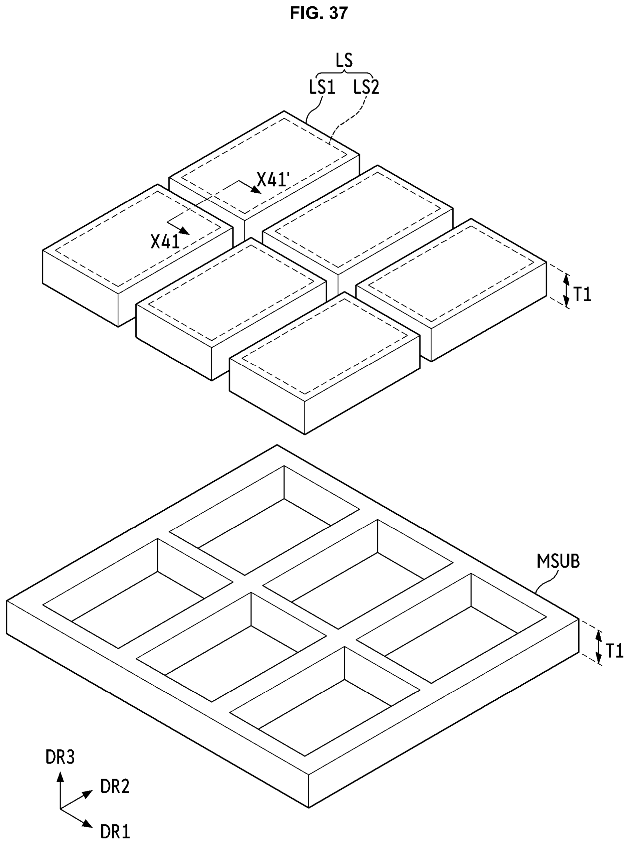

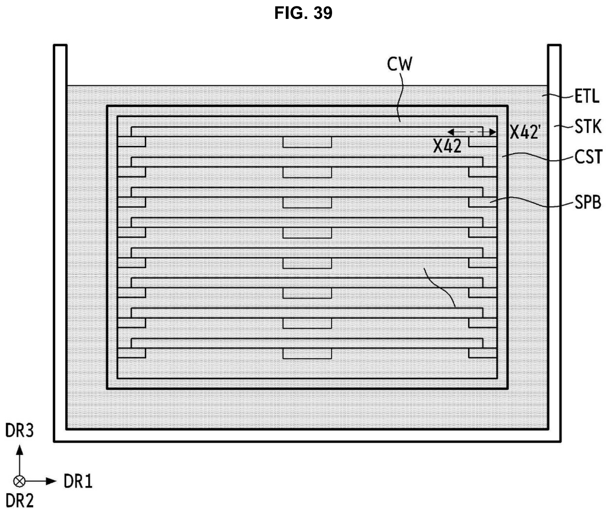

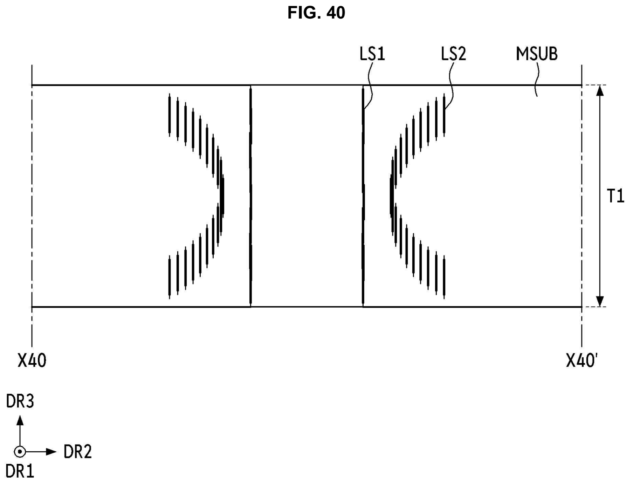

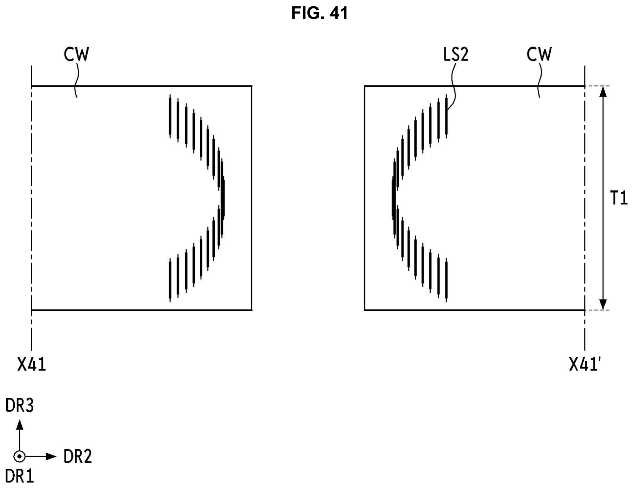

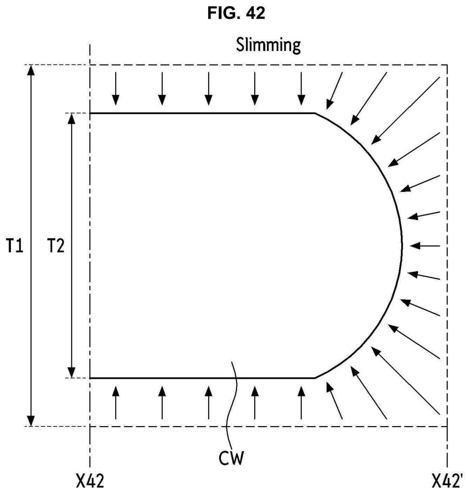

FIG. 35 is a flowchart illustrating a method of manufacturing a cover window according to one or more embodiments of the present invention. FIGS. 36 through 39 are perspective views for explaining a method of manufacturing a display device according to one or more embodiments. FIG. 40 is a cross-sectional view illustrating an example of a cross section of a mother substrate MSUB taken along the line X40-X40' of FIG. 36 according to one or more embodiments. FIG. 41 is a cross-sectional view illustrating an example of a cross section of a cover window CW taken along the line X41-X41' of FIG. 37 according to one or more embodiments. FIG. 42 is a cross-sectional view illustrating an example of a cross section of a cover window CW taken along the line X42-X42' of FIG. 39 according to one or more embodiments.

A method of manufacturing the side surfaces SS1 through SS4 of the cover window CW described above with reference to FIGS. 19 through 22 will now be described in more detail with reference to FIGS. 35 through 42.

First, as illustrated in FIGS. 36, 37, 40 and 41, a laser beam BM is irradiated to an area of the mother substrate MSUB to cut out a plurality of cover windows CW from the mother substrate MSUB (operation S100 of FIG. 35)

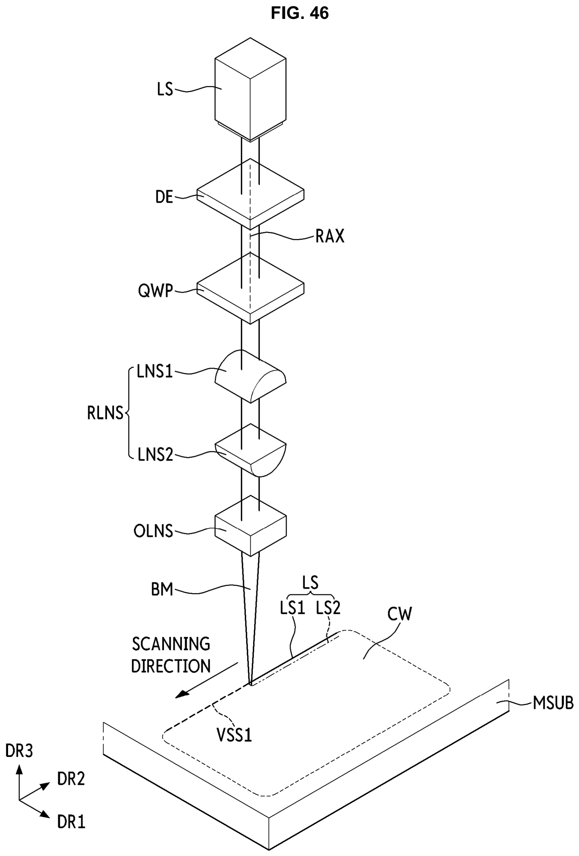

As illustrated in FIGS. 36 and 40, a laser device LD scans the laser beam BM along set or predetermined virtual lines to cut out the cover windows CW. The laser device LD scans the laser beam BM along a virtual line corresponding to a first side surface SS1 of any one of the cover windows CW. Then, the laser device LD scans the laser beam BM along virtual lines corresponding to a second side surface SS2, a third side surface SS3, and a fourth side surface SS4 of the any one cover window CW. When the laser device LD completes scanning the laser beam BM along virtual lines corresponding to any one of the cover windows CW, it starts to scan the laser beam BM along virtual lines corresponding to another cover window CW. The laser device LD sequentially completes scanning the laser beam BM for all of the cover windows CW. The scanning of the laser beam BM for one cover window CW will be described in more detail later with reference to FIGS. 46 through 53.

As illustrated in FIG. 37 and FIG. 41, the cover windows CW may be separated from the mother substrate MSUB by the scanning of the laser beam BM. In addition, a plurality of laser spots LS may be formed along edges of each of the cover windows CW by the scanning of the laser beam BM. The laser spots LS include a plurality of first laser spots LS1 and a plurality of second laser spots LS2.

The first laser spots LS1 are laser spots for separating the cover windows CW from the mother substrate MSUB. The first laser spots LS1 may be arranged in a 1-shape or an I-shape on a plane defined by the first direction DR1 and the third direction DR3. The first laser spots LS1 may overlap each other in the third direction DR3. For example, a distance between neighboring first laser spots LS1 among the first laser spots LS1 in the first direction DR1 or the second direction DR2 may be 0 µm to about 2 µm.

The second laser spots LS2 may be laser spots for forming the side surfaces SS1 through SS4 of the cover windows CW to have a selected radius of curvature. The second laser spots LS2 may be spaced and/or apart (e.g., spaced apart or separated) from the first laser spots LS1 in the first direction DR1 or the second direction DR2. The second laser spots LS2 may be arranged in a C shape on the plane defined by the first direction DR1 and the third direction DR3.

In summary, the cover windows CW may be separated from the mother substrate MSUB by the first laser spots LS1, and the second laser spots LS2 may be formed along the edges of each of the cover windows CW.

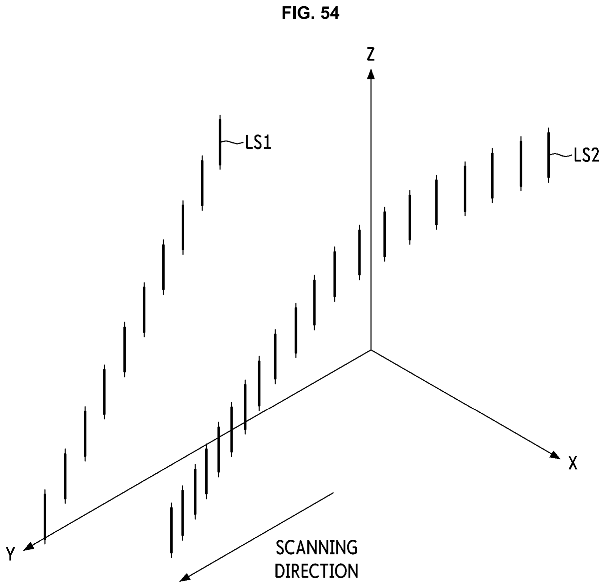

The first laser spots LS1 and the second laser spots LS2 will be described in more detail later with reference to FIGS. 54 through 56.

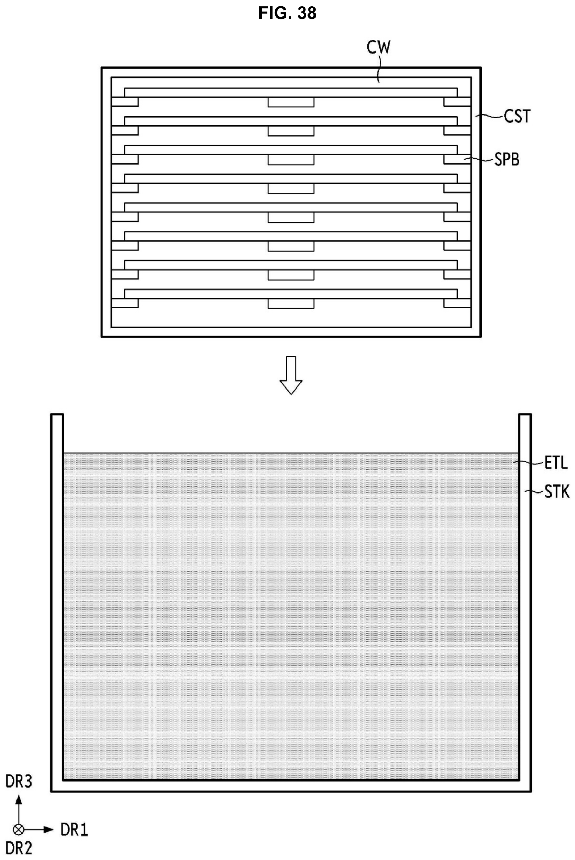

Second, as illustrated in FIG. 38, the cover windows CW separated from the mother substrate MSUB are loaded into a cassette CST (operation S200 of FIG. 35).

The cassette CST may include a plurality of storage spaces that can store the cover windows CW. The cassette CST includes a plurality of supports SPB that can support central and edge portions of each of the cover windows CW. The supports SPB may overlap each other in the third direction DR3, and the cover windows CW may be arranged in the third direction DR3 within the cassette CST.

Third, as illustrated in FIGS. 39 and 42, the cover windows CW are etched using an etchant ETL (operation S300 of FIG. 35).

The cassette CST having the cover windows CW is immersed in the etchant ETL of an etchant storage tank STK in which the etchant ETL is stored. Accordingly, the cover windows CW may be etched.

For example, as illustrated in FIG. 42, a thickness of each of the cover windows CW may be reduced from a first thickness T1 to a second thickness T2. The thickness of each of the cover windows CW may be reduced by about 20% to about 50%.

In addition, the first side surface SS1 of each of the cover windows CW may include a plurality of etch pores POR (see FIG. 23) formed by etching along the second laser spots LS2. A length of each of the second laser spots LS2 in the third direction DR3 is about 2 µm to about 20 µm, and the second laser spots LS2 are spaced and/or apart (e.g., spaced apart or separated) from each other by about 5 µm to about 15 µm in the second direction DR2. Therefore, the etch pores POR (see FIG. 23) may be formed due to an etching difference between the second laser spots LS2 and an area between the second laser spots LS2.

As illustrated in FIGS. 35 through 42, each of the cover windows CW may be formed to have the curved side surfaces SS1 through SS4 having a selected radius of curvature only by a laser process using the laser device LD and an etching process using an etchant. Therefore, when the cover windows CW are manufactured, it may prevent defects such as chipping due to a CNC process, thereby reducing manufacturing costs.

In addition, because the side surfaces SS1 through SS4 of each of the cover windows CW are formed in a curved shape having a selected radius of curvature along the second laser spots LS2, they may have a shape advantageous for absorbing impact. Therefore, it may prevent a reduction in the mechanical strength, such as side strength, of each of the side surfaces SS1 through SS4 of each of the cover windows CW.

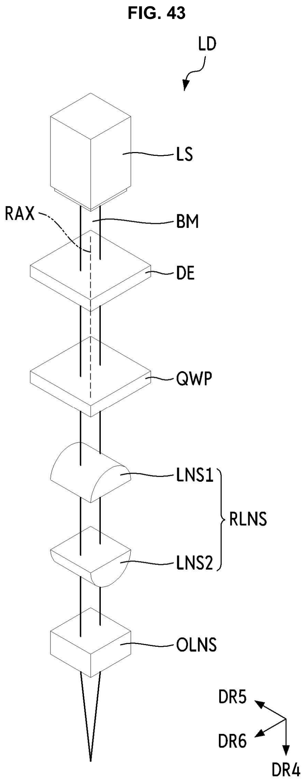

FIG. 43 is a perspective view of a laser device LD according to one or more embodiments of the present invention.

Referring to FIG. 43, the laser device LD according to one or more embodiments includes a light source LS, a diffractive element DE, a phase retardation plate QWP, a relay lens RLNS, and an objective lens OLNS.

The light source LS may be any of various suitable laser generators. The light source LS may be to emit a laser beam BM. The light source LS may be to emit the laser beam BM continuously or discontinuously. The light source LS may be to emit a linearly or circularly polarized laser beam BM. The light source LS may output a single pulse laser beam BM or a burst pulse laser beam BM including a plurality of pulses.

The pulse duration, burst pulse, pulse energy, repetition rate, and/or the like of the laser beam BM may be adjusted by the light source LS. For example, in one or more embodiments, the pulse duration (or pulse width) of the laser beam BM may be about 300 femtoseconds (fs) to 10 picoseconds (ps). The pulse energy of the laser beam BM may be about 10 µJ to about 70 µJ, and thus processing energy per individual spot may be 3 µJ/spot. The repetition rate of the laser beam BM may be about 10 kHz to about 1,000 kHz. When the light source LS outputs a burst pulse laser beam BM, the burst pulse of the laser beam BM may be about 2 to 5 pulses.

Various laser beams may be used as the laser beam BM according to one or more embodiments. However, in the present invention, the laser beam BM may be an infrared beam having a wavelength band of about 800 nm to 1,100 nm.

The diffractive element DE includes diffractive patterns for causing the laser beam BM incident on the diffractive element DE to be focused on multiple laser spots. The diffractive element DE may be a diffractive optical element with fixed diffractive patterns or a spatial light modulator that can actively change diffractive patterns.

The diffractive element DE may be configured to be rotated clockwise or counterclockwise about a rotation axis RAX in a fourth direction DR4 by a rotational motor. The rotation axis RAX of the diffractive element DE may pass through a center of the diffractive element DE in a plane defined by a fifth direction DR5 and a sixth direction DR6. The plane defined by the fifth direction DR5 and the sixth direction DR6 may be a plane orthogonal to the fourth direction DR4.

The rotational motor is configured to rotate the diffractive element DE about the rotation axis RAX in the fourth direction DR4. The rotational motor may rotate the diffractive element DE by a desired or suitable angle in the range of 0 to 360 degrees. Various suitable motors such as a hollow motor, a stepping motor, a servo motor, and a brushless motor may be used as the rotational motor.

The phase retardation plate QWP may be a λ/4 plate which retards the phase of incident light by λ/4. Because the phase retardation plate QWP retards the phase of the laser beam BM output from the diffractive element DE by λ/4, even if the laser beam BM output from the light source LS is linearly or circularly polarized, the laser device LD may output the laser beam BM elliptically polarized by the phase retardation plate QWP.

In one or more embodiments, the relay lens RLNS may be arranged between the phase retardation plate QWP and the objective lens OLNS. In one or more embodiments, the relay lens RLNS may be arranged between the light source LS and the diffractive element DE. For example, the relay lens RLNS may be arranged between the phase retardation plate QWP and the objective lens OLNS or between the light source LS and the diffractive element DE.

The relay lens RLNS includes a first lens LNS1 and a second lens LNS2. The first lens LNS1 may be arranged adjacent to the phase retardation plate QWP, and the second lens LNS2 may be arranged adjacent to the objective lens OLNS. The first lens LNS1 may be a convex lens protruding toward the phase retardation plate QWP, and the second lens LNS2 may be a convex lens protruding toward the objective lens OLNS. The relay lens RLNS may relay light at a ratio of *n*:1 or at a ratio of 1:*n*, where *n* is a positive integer.

The objective lens OLNS may focus the laser beam BM, which passes through the relay lens RLNS, at a set or predetermined distance.

The light source LS, the diffractive element DE, the phase retardation plate QWP, the relay lens RLNS, and the objective lens OLNS of the laser device LD may be arranged side by side in the fourth direction DR4.

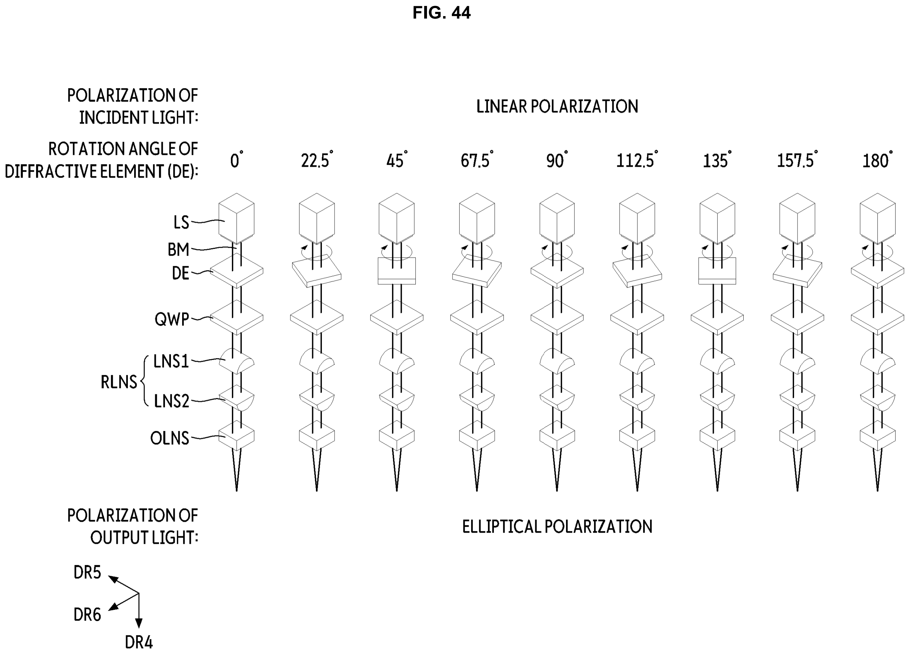

FIG. 44 is an example diagram illustrating the polarization of an output beam according to the rotation of the laser device LD according to one or more embodiments.

Referring to FIG. 44, when the laser device LD rotates, the light source LS, the phase retardation plate QWP, the relay lens RLNS, and the objective lens OLNS do not rotate, and only the diffractive element DE rotates. Therefore, regardless of the rotation of the laser device LD, the light source LS outputs a linearly polarized laser beam BM oscillating in the sixth direction DR6. The diffractive element DE may rotate from 0 degrees to 360 degrees with respect to the sixth direction DR6 in a plane defined by the fourth direction DR4 and the sixth direction DR6.

Because the phase retardation plate QWP retards the phase of an incident linearly polarized laser beam BM by λ/4, the laser beam BM output from the phase retardation plate QWP has elliptical polarization. Therefore, when the diffractive element DE is rotated by 0, 22.5, 45, 67.5, 90, 112.5, 135, 157.5, and 180 degrees with respect to the sixth direction DR6, the laser device LD outputs the elliptically polarized laser beam BM. For example, regardless of the rotation of the diffractive element DE, the laser device LD outputs the elliptically polarized laser beam BM.

As illustrated in FIG. 44, the laser device LD according to one or more embodiments includes the phase retardation plate QWP to prevent the polarization of the laser beam BM from being changed by the rotation of the diffractive element DE of the laser device LD. Therefore, even if the light source LS outputs the laser beam BM having linear polarization and the diffractive element DE rotates, the laser device LD may output the laser beam BM having elliptical polarization. Therefore, it may minimize or reduce a difference in the processing of a cover window CW according to the polarization of the laser beam BM.

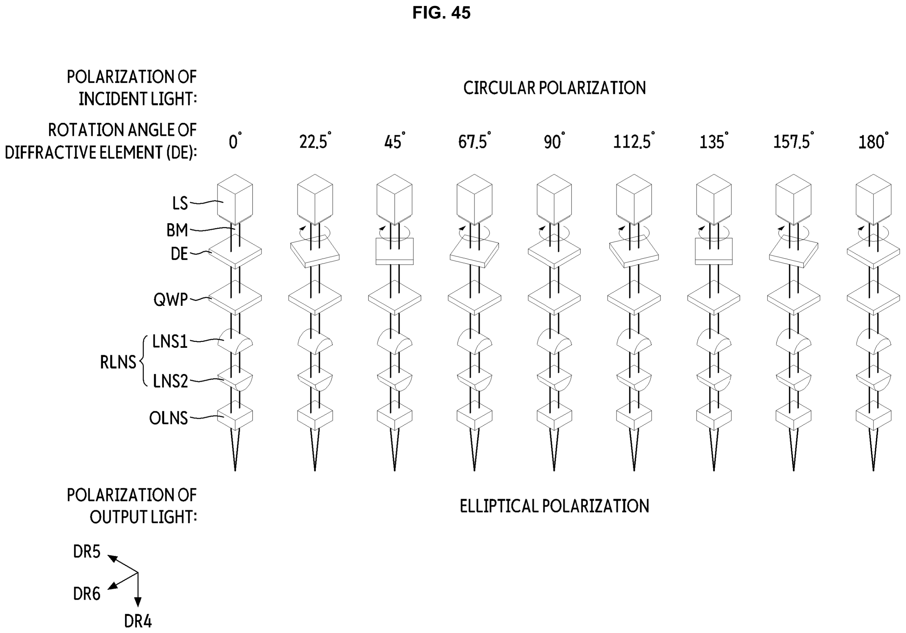

FIG. 45 is an example diagram illustrating the polarization of an output beam according to the rotation of the laser device LD according to one or more embodiments.

Referring to FIG. 45, when the laser device LD rotates, the light source LS, the phase retardation plate QWP, the relay lens RLNS, and the objective lens OLNS do not rotate, and only the diffractive element DE rotates. Therefore, regardless of the rotation of the laser device LD, the light source LS outputs a laser beam BM having circular polarization. The diffractive element DE may rotate from 0 degrees to 360 degrees with respect to the sixth direction DR6 in a plane defined by the fourth direction DR4 and the sixth direction DR6.

Because the phase retardation plate QWP retards the phase of an incident circularly polarized laser beam BM by λ/4, the laser beam BM output from the phase retardation plate QWP has elliptical polarization. Therefore, when the diffractive element DE is rotated by 0, 22.5, 45, 67.5, 90, 112.5, 135, 157.5, and 180 degrees with respect to the sixth direction DR6, the laser device LD outputs the elliptically polarized laser beam BM. For example, regardless of the rotation of the diffractive element DE, the laser device LD outputs the elliptically polarized laser beam BM.

As illustrated in FIG. 45, the laser device LD according to one or more embodiments includes the phase retardation plate QWP to prevent the polarization of the laser beam BM from being changed by the rotation of the diffractive element DE of the laser device LD. Therefore, even if the light source LS outputs the laser beam BM having circular polarization and the diffractive element DE rotates, the laser device LD may output the laser beam BM having elliptical polarization. Therefore, it may minimize or reduce a difference in the processing of a cover window CW according to the polarization of the laser beam BM.

FIGS. 46 through 53 are perspective views illustrating laser beam scanning of one cover window in more detail according to one or more embodiments.

The laser beam scanning of one cover window described with reference to operation S100 of FIG. 35 and FIG. 36 will now be described in more detail with reference to FIGS. 46 through 53.

First, as illustrated in FIG. 46, in a state where the laser device LD is rotated 0 degrees (or is not rotated), it scans a laser beam BM along a first side virtual line VSS1 corresponding to a first side surface SS1 of any one of a plurality of cover windows CW. The state where the laser device LD is rotated 0 degrees (or is not rotated) refers to a state where, in a plane defined by the first direction DR1 and the second direction DR2, first sides of the diffractive element DE of the laser device LD which face each other are arranged in a direction parallel to the first direction DR1, and second sides of the diffractive element DE which face each other are arranged in a direction parallel to the second direction DR2.

The first side virtual line VSS1 may be a line extending from an end of the first side surface SS1 of the cover window CW to the other end. Because the first side virtual line VSS1 extends in the second direction DR2, a scanning direction of the laser device LD may be parallel to the second direction DR2. Because the first side virtual line VSS1 is a straight line, the laser device LD irradiates the laser beam BM while moving in a straight line. In this regard, a scanning speed of the laser device LD may be about 10 mm/sec to about 500 mm/sec.

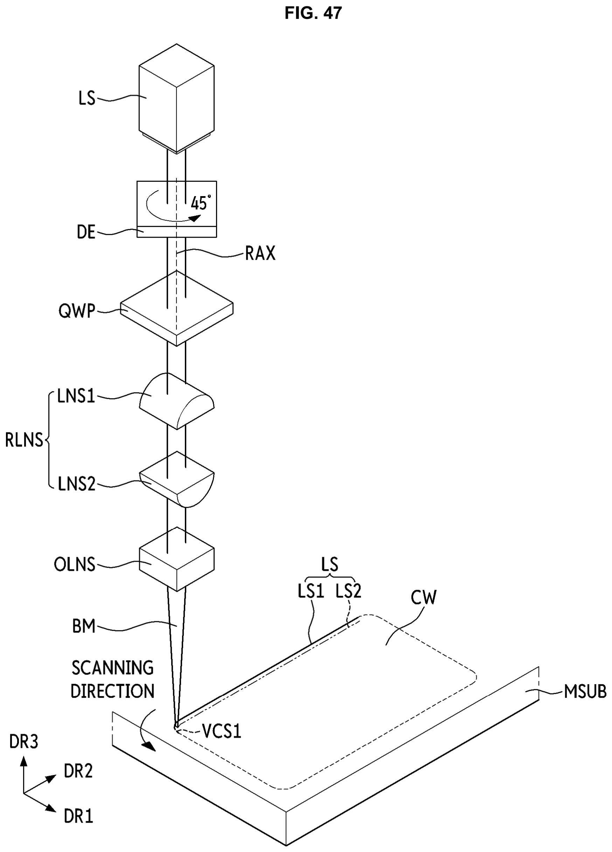

Second, as illustrated in FIG. 47, the laser device LD scans the laser beam BM along a first corner virtual line VCS1 corresponding to a first corner side surface CS1 of the cover window CW while continuously rotating counterclockwise from 0 degrees to about 90 degrees. The diffractive element DE of the laser device LD may continuously rotate counterclockwise from 0 degrees to about 90 degrees about the rotation axis RAX in the third direction DR3.

The first corner virtual line VCS1 may be a line extending from an end of the first corner CS1 of the cover window CW to the other end. Because the first corner virtual line VCS1 is a curve, the laser device LD irradiates the laser beam BM while moving in a curve. In this regard, the scanning speed of the laser device LD may be about 10 mm/sec to about 100 mm/sec. For example, the scanning speed of the laser device LD moving along the first corner virtual line VCS1 may be lower than the scanning speed of the laser device LD moving along the first side virtual line VSS1.

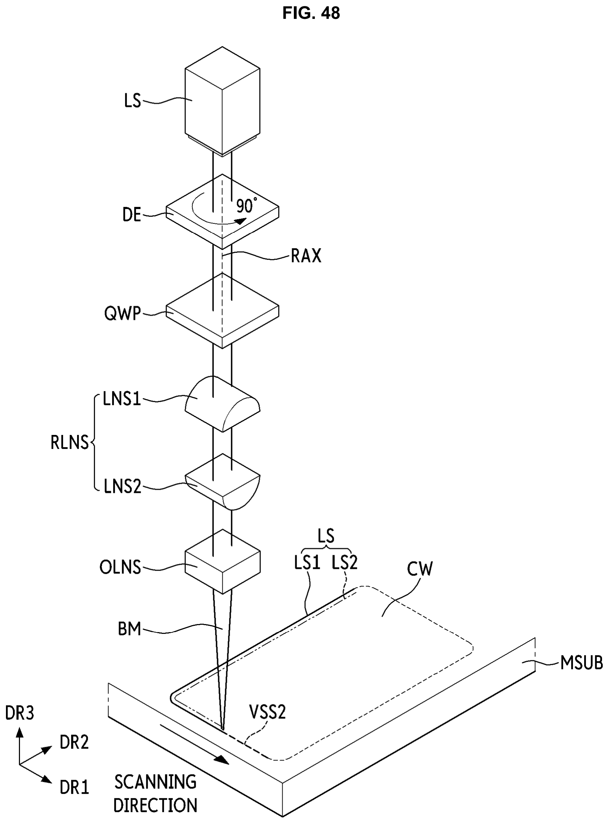

Third, as illustrated in FIG. 48, in a state where the laser device LD is rotated about 90 degrees counterclockwise, it scans the laser beam BM along a second side virtual line VSS2 corresponding to a second side surface SS2 of the cover window CW. The state where the laser device LD is rotated about 90 degrees counterclockwise refers to a state where the laser device LD is rotated about 90 degrees counterclockwise from 0 degrees about the rotation axis RAX in the third direction DR3.

The second side virtual line VSS2 may be a line extending from an end of the second side surface SS2 of the cover window CW to the other end. Because the second side virtual line VSS2 extends in the first direction DR1, the scanning direction of the laser device LD may be parallel to the first direction DR1. Because the second side virtual line VSS2 is a straight line, the laser device LD irradiates the laser beam BM while moving in a straight line. In this regard, the scanning speed of the laser device LD may be about 10 mm/sec to about 500 mm/sec.

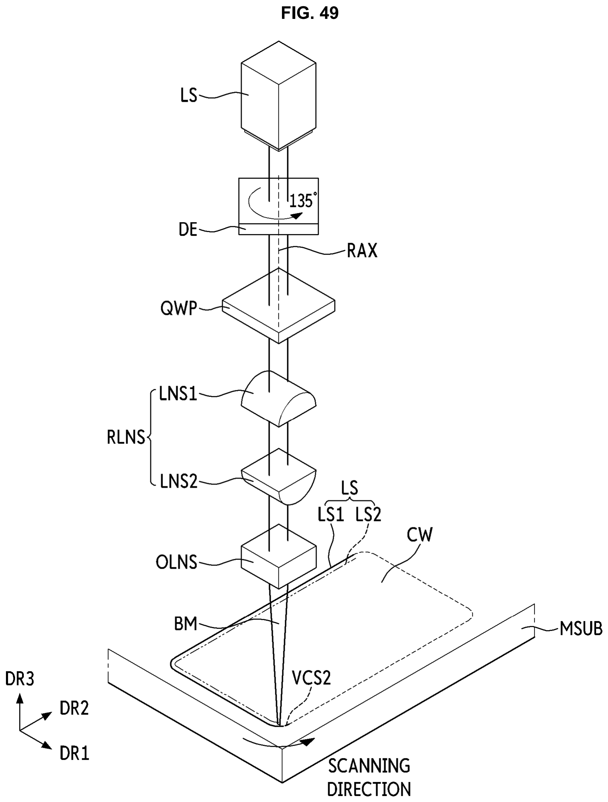

Fourth, as illustrated in FIG. 49, the laser device LD scans the laser beam BM along a second corner virtual line VCS2 corresponding to a second corner side surface CS2 of the cover window CW while continuously rotating counterclockwise from about 90 degrees to about 180 degrees. The diffractive element DE of the laser device LD may continuously rotate counterclockwise from about 90 degrees to about 180 degrees about the rotation axis RAX in the third direction DR3.

The second corner virtual line VCS2 may be a line extending from an end of the second corner CS2 of the cover window CW to the other end. Because the second corner virtual line VCS2 is a curve, the laser device LD irradiates the laser beam BM while moving in a curve. In this regard, the scanning speed of the laser device LD may be about 10 mm/sec to about 100 mm/sec/sec. For example, the scanning speed of the laser device LD moving along the second corner virtual line VCS2 may be lower than the scanning speed of the laser device LD moving along the second side virtual line VSS2.

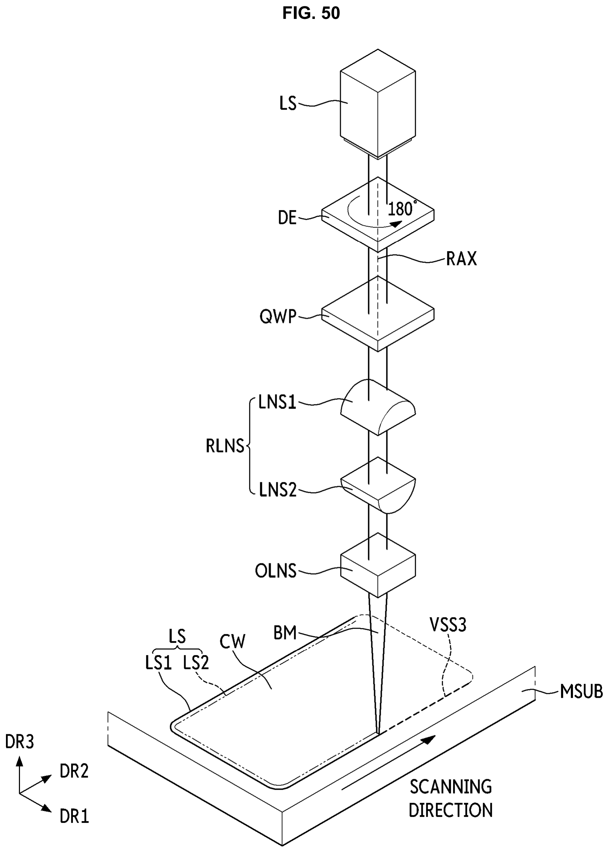

Fifth, as illustrated in FIG. 50, in a state where the laser device LD is rotated about 180 degrees counterclockwise, it scans the laser beam BM along a third side virtual line VSS3 corresponding to a third side surface SS3 of the cover window CW. The state where the laser device LD is rotated about 180 degrees counterclockwise refers to a state where the laser device LD is rotated about 180 degrees counterclockwise from 0 degrees about the rotation axis RAX in the third direction DR3.

The third side virtual line VSS3 may be a line extending from an end of the third side surface SS3 of the cover window CW to the other end. Because the third side virtual line VSS3 extends in the second direction DR2, the scanning direction of the laser device LD may be parallel to the second direction DR2. Because the third side virtual line VSS3 is a straight line, the laser device LD irradiates the laser beam BM while moving in a straight line. In this regard, the scanning speed of the laser device LD may be about 10 mm/sec to about 500 mm/sec/sec.

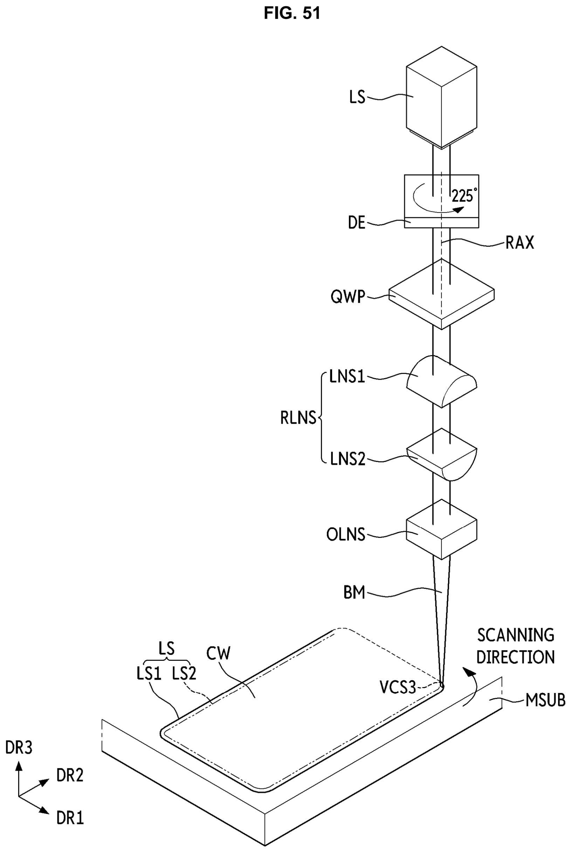

Sixth, as illustrated in FIG. 51, the laser device LD scans the laser beam BM along a third corner virtual line VCS3 corresponding to a third corner side surface CS3 of the cover window CW while continuously rotating counterclockwise from about 180 degrees to about 270 degrees. The diffractive element DE of the laser device LD may continuously rotate counterclockwise from about 180 degrees to about 270 degrees about the rotation axis RAX in the third direction DR3.

The third corner virtual line VCS3 may be a line extending from an end of the third corner CS3 of the cover window CW to the other end. Because the third corner virtual line VCS3 is a curve, the laser device LD irradiates the laser beam BM while moving in a curve. In this regard, the scanning speed of the laser device LD may be about 10 mm/sec to 100 mm/sec/sec. For example, the scanning speed of the laser device LD moving along the third corner virtual line VCS3 may be lower than the scanning speed of the laser device LD moving along the third side virtual line VSS3.

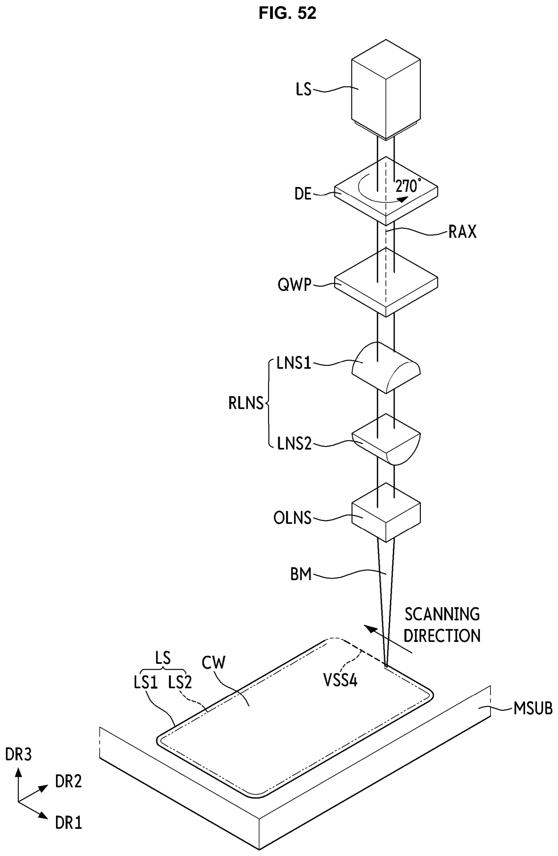

Seventh, as illustrated in FIG. 52, in a state where the laser device LD is rotated about 270 degrees counterclockwise, it scans the laser beam BM along a fourth side virtual line VSS4 corresponding to a fourth side surface SS4 of the cover window CW. The state where the laser device LD is rotated about 270 degrees counterclockwise refers to a state where the laser device LD is rotated about 270 degrees counterclockwise from 0 degrees about the rotation axis RAX in the third direction DR3.

The fourth side virtual line VSS4 may be a line extending from an end of the fourth side surface SS4 of the cover window CW to the other end. Because the fourth side virtual line VSS4 extends in the first direction DR1, the scanning direction of the laser device LD may be parallel to the first direction DR1. Because the fourth side virtual line VSS4 is a straight line, the laser device LD irradiates the laser beam BM while moving in a straight line. In this regard, the scanning speed of the laser device LD may be about 10 mm/sec to about 500 mm/sec/sec.

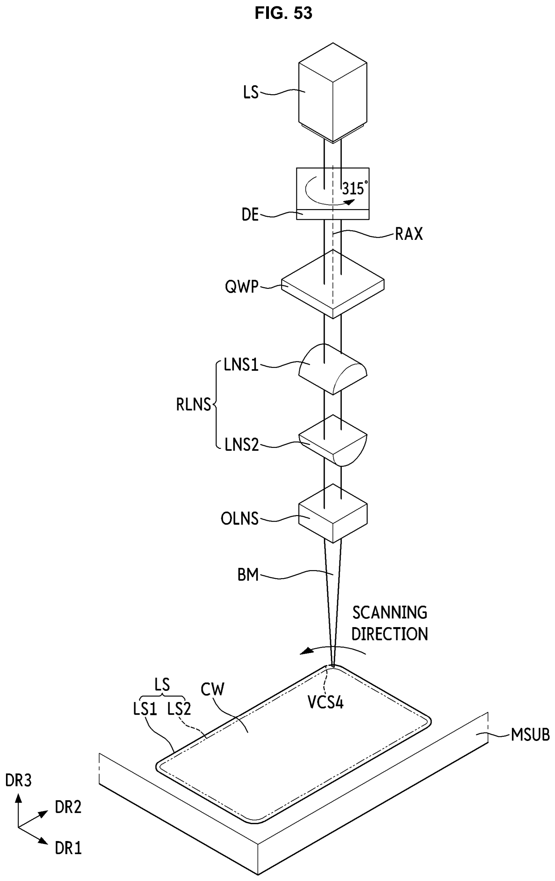

Eighth, as illustrated in FIG. 53, the laser device LD scans the laser beam BM along a fourth corner virtual line VCS4 corresponding to a fourth corner side surface CS4 of the cover window CW while continuously rotating counterclockwise from about 270 degrees to about 360 degrees. The diffractive element DE of the laser device LD may continuously rotate counterclockwise from about 270 degrees to about 360 degrees about the rotation axis RAX in the third direction DR3.

The fourth corner virtual line VCS4 may be a line extending from an end of the fourth corner CS4 of the cover window CW to the other end. Because the fourth corner virtual line VCS4 is a curve, the laser device LD irradiates the laser beam BM while moving in a curve. In this regard, the scanning speed of the laser device LD may be about 10 mm/sec to about 100 mm/sec/sec. For example, the scanning speed of the laser device LD moving along the fourth corner virtual line VCS4 may be lower than the scanning speed of the laser device LD moving along the fourth side virtual line VSS4.

When the laser device LD scans the laser beam BM along the first side virtual line VSS1, the first corner virtual line VCS1, the second side virtual line VSS2, the second corner virtual line VCS2, the third side virtual line VSS3, the third corner virtual line VCS3, the fourth side virtual line VSS4, and the fourth corner virtual line VCS4 as illustrated in FIGS. 46 through 53, a plurality of first laser spots LS1 for cutting out the cover window CW and a plurality of second laser spots LS2 for forming the side surfaces of the cover window CW into a curved shape may be formed. The first laser spots LS1 and the second laser spots LS2 may be arranged along edges of an area corresponding to the cover window CW.

The laser device LD may scan the laser beam BM multiple times at each of the first side virtual line VSS1, the first corner virtual line VCS1, the second side virtual line VSS2, the second corner virtual line VCS2, the third side virtual line VSS3, the third corner virtual line VCS3, the fourth side virtual line VSS4, and the fourth corner virtual line VCS4. When the laser device LD scans the laser beam BM once, about 10 laser spots to about 50 laser spots LS may be formed in a space within about 200 µm in the first direction DR1, within about 160 µm in the second direction DR2, and within about 160 µm in the third direction DR3. The number of first laser spots LS1 and the number of second laser spots LS2 formed by one laser beam scan may be different.

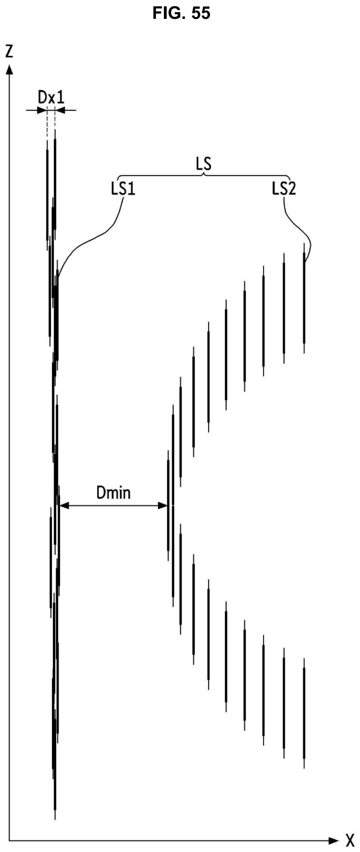

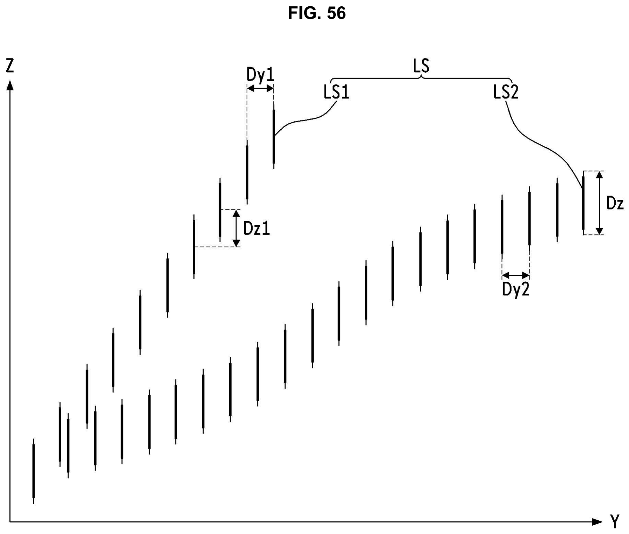

FIGS. 54 through 56 are example drawings illustrating laser spots formed by one laser scan. FIG. 54 illustrates laser spots LS in an XYZ plane, FIG. 55 illustrates laser spots LS in an XZ plane, and FIG. 56 illustrates laser spots LS in a YZ plane.

In FIGS. 54 through 56, a Y-axis direction may be a scanning direction of the laser device LD, a Z-axis direction may be the third direction DR3 which is a thickness direction of a mother substrate MSUB or a cover window CW, and an X-axis direction may be a direction orthogonal to the Y-axis direction and the Z-axis direction.

Referring to FIGS. 54 through 56, laser spots LS arranged in the X-axis direction may have a length of about 200 µm or less. Laser spots LS arranged in the Y-axis direction may have a length of about 160 µm or less. Laser spots LS arranged in the Z-axis direction may have a length of about 160 µm or less.

A plurality of first laser spots LS1 may be arranged in a 1-shape or an I-shape in the XZ plane. A distance Dx1 between neighboring first laser spots LS1 among the first laser spots LS1 in the X-axis direction may be about 0 µm to about 2 µm. A distance Dy1 between neighboring first laser spots LS1 among the first laser spots LS1 in the Y-axis direction be about 5 µm to about 15 µm. A distance Dz1 between centers of neighboring first laser spots LS1 among the first laser spots LS1 in the Z-axis direction may be about 5 µm to about 15 µm.

A plurality of second laser spots LS2 may be arranged in a C shape in the XZ plane. In the XZ plane, at least two of the second laser spots LS2 may overlap each other in the Z-axis direction. A distance Dy2 between neighboring second laser spots LS2 among the second laser spots LS2 may be about 5 µm to about 15 µm. Each of the first laser spots LS1 and the second laser spots LS2 may have a length Dz of about 1 µm to about 20 µm in the Z-axis direction. A minimum distance Dmin between the first laser spots LS1 and the second laser spots LS2 in the X-axis direction may be about 3 µm or greater.

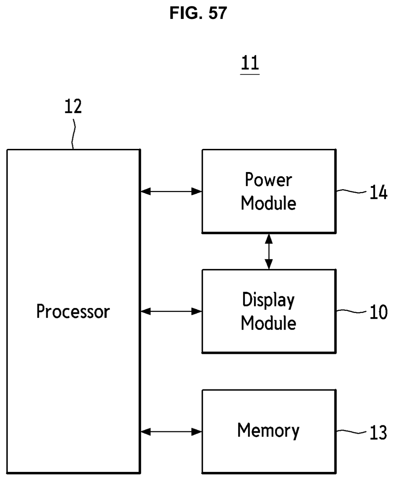

FIG. 57 is a block diagram of an electronic device 11 according to one or more embodiments.

Referring to FIG. 57, a display module 10 according to one or more embodiments may be applied to one or more suitable electronic devices. The electronic device 11 according to one or more embodiments may include the display module 10 described above and may further include modules or devices having other additional functions, in addition to the display module 10.

The electronic device 11 according to one or more embodiments may include a display module 10, a processor 12, a memory 13, and a power module 14.

The processor 12 may include at least one of a central processing unit (CPU), an application processor (AP), a graphic processing unit (GPU), a communication processor (CP), an image signal processor (ISP), or a controller.

The memory 13 may store data information necessary for operations of the processor 12 and/or the display module 10. When the processor 12 executes an application stored in the memory 13, an image data signal and/or an input control signal may be transmitted to the display module 10, and the display module 10 may process the received signal and output image information through a display screen.

The power module 14 may include a power supply module such as a power adapter and/or a battery device and a power conversion module which generates power necessary for the operation of the electronic device 11 by converting power supplied by the power supply module.

At least one of the components of the electronic device 11 described above may be included in the display device according to one or more embodiments described above. In addition, some of individual modules functionally included in one module may be included in the display device, and other modules may be provided separately from the display device. For example, the display device may include the display module 10, and the processor 12, the memory 13, and the power module 14 may be provided not in the display device but in the form of other devices within the electronic device 11.

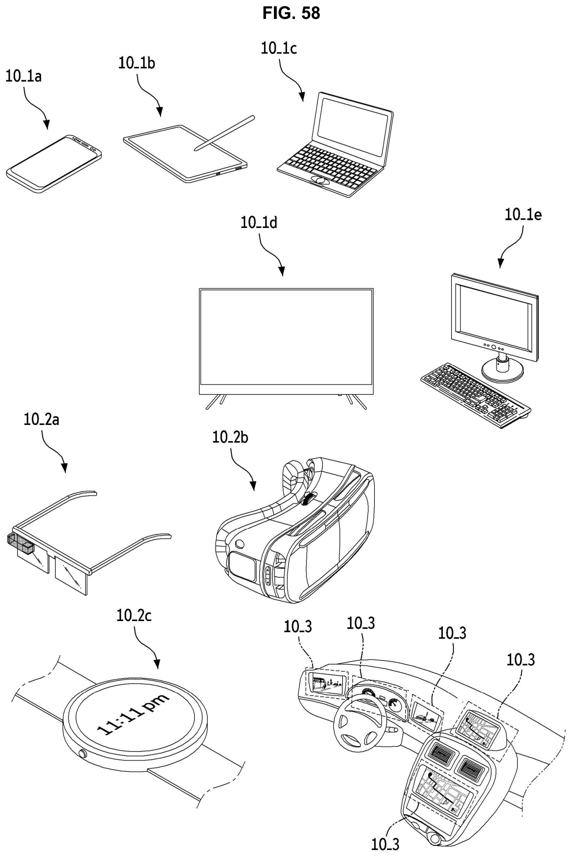

FIG. 58 is a schematic diagram of electronic devices according to various embodiments of the present invention.

Referring to FIG. 58, one or more suitable electronic devices to which display modules 10 according to one or more embodiments are applied may include not only image display electronic devices such as a smartphone 10_1a, a tablet PC 10_1b, a laptop 10_1c, a television 10_1d, and a desk monitor 10_1e, but also wearable electronic devices including display modules, such as smart glasses 10_2a, a head mounted display 10_2b, and a smart watch 10_2c, and may also include vehicle electronic devices 10_3 including display modules, such as a center information display (CID) and a room mirror display placed on an instrument panel, center fascia and dashboard of a vehicle.

In the present invention, it will be understood that the terms "comprise(s)/comprising," "include(s)/including," or "have/has/having" specify the presence of stated features, integers, steps, operations, elements, and/or components, but do not preclude the presence or addition of one or more other features, integers, steps, operations, elements, components, and/or groups thereof. Additionally, the terms "comprise(s)/comprising," "include(s)/including," "have/has/having," or other similar terms include or support the terms "consisting of" and "consisting essentially of," indicating the presence of stated features, integers, steps, operations, elements, and/or components, without or essentially without the presence of other features, integers, steps, operations, elements, components, and/or groups thereof.

As utilized herein, the singular forms "a," "an," "one," and "the" are intended to include the plural forms as well, unless the context clearly indicates otherwise. Further, the use of "may" when describing embodiments of the present invention refers to "one or more embodiments of the present invention".

In the present invention, expressions such as "at least one of," "one of," and "selected from," when preceding a list of elements, modify the entire list of elements and do not modify the individual elements of the list. For example, "at least one of a, b or c", "at least one selected from a, b, and c", "at least one selected from among a to c", etc., may indicate only a, only b, only c, both (e.g., simultaneously) a and b, both (e.g., simultaneously) a and c, both (e.g., simultaneously) b and c, all of a, b, and c, or variations thereof.

In the context of the present application and unless otherwise defined, the terms "use," "using," and "used" may be considered synonymous with the terms "utilize," "utilizing," and "utilized," respectively.

As utilized herein, the terms "substantially," "about," "approximately," or similar terms are used as terms of approximation and not as terms of degree, and are intended to account for the inherent deviations in measured or calculated values that would be recognized by those of ordinary skill in the art. "About" or "approximately" as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, or 5% of the stated value.

Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in the present disclosure is intended to include all higher numerical limitations subsumed therein.

The light emitting element, the display panel, the display device, the electronic device/apparatus, the cover window-manufacturing apparatus (e.g., adhesive member-manufacturing apparatus), or any other relevant devices or components according to embodiments of the present invention described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present invention.

A person of ordinary skill in the art would appreciate, in view of the present disclosure in its entirety, that each suitable feature of the various embodiments of the present invention may be combined or combined with each other, partially or entirely, and may be technically interlocked and operated in various suitable ways, and each embodiment may be implemented independently of each other or in conjunction with each other in any suitable manner unless otherwise stated or implied.

Although one or more embodiments of the present invention have been described with reference to the accompanying drawings, those skilled in the art will understand that the present invention may be implemented in other specific forms without changing the technical idea or essential features of the invention. Therefore, it should be understood that one or more embodiments described above are mere examples in all respects and not restrictive. It is further to be understood that the scope of the present invention are defined by the appended claims rather than the detailed description described above.

## Claims

1. A cover window (CW) comprising:
a first surface (FS);
a second surface (BS) opposite to the first surface (FS); and
a plurality of side surfaces (SS1-SS4) between the first surface (FS) and the second surface (BS),
wherein a radius of curvature of each of the side surfaces (SS1-SS4) is about 15 µm to about 25 µm, a first side surface (SS1) selected from among the side surfaces (SS1-SS4) comprises a plurality of etch pores (POR), and a difference between a maximum height and a minimum height of the etch pores (POR) overlapping each other in a direction (DR2) in which the first side surface (SS1) extends is about 0.1 µm to about 0.5 µm.

2. The cover window (CW) of claim 1, wherein a difference between a radius of curvature of a second side surface (SS2) and a radius of curvature of the first side surface (SS1) among the side surfaces (SS1-SS4) is about 2.5 µm or less.

3. The cover window (CW) of claim 1 or 2, wherein a width (Wss1) of the first side surface (SS1) is about 10 µm to about 20 µm.

4. The cover window (CW) of at least one of claims 1 to 3, wherein the cover window (CW) has a thickness (Tcw) of about 30 µm to about 60 µm.

5. A method of manufacturing a cover window (CW), especially a cover window (CW) according to at least one of claims 1 to 4, the method comprising the following steps:
irradiating a laser beam (BM) to an area of a mother substrate (MSUB) which corresponds to a plurality of cover windows (CW) utilizing a laser device (LD) to separate the cover windows (CW) from the mother substrate (MSUB) and form laser spots (LS) on edges of each of the cover windows (CW);
loading the cover windows (CW) into a cassette (CST); and
etching the cover windows (CW) of the cassette (CST) utilizing an etchant (ETL) to reduce a thickness of each of the cover windows (CW) and form side surfaces (SS1-SS4) of each of the cover windows (CW).

6. The method of claim 5, wherein a radius of curvature of each of the side surfaces (SS1-SS4) of each of the cover windows (CW) is about 15 µm to about 25 µm.

7. The method of claim 5 or 6, wherein the irradiating of the laser beam (BM) to the area of the mother substrate (MSUB) which corresponds to the cover windows (CW) utilizing the laser device (LD) to separate the cover windows (CW) from the mother substrate (MSUB) and form the laser spots (LS) on the edges of each of the cover windows (CW) comprises scanning the laser beam (BM) multiple times in an area corresponding to any one of the cover windows (CW).

8. The method of claim 7, wherein one scan of the laser beam (BM) comprises a plurality of first laser spots (LS1) and a plurality of second laser spots (LS2), and the first laser spots (LS1) and the second laser spots (LS2) do not overlap each other in a thickness direction (DR3) of the cover window (CW).

9. The method of claim 8, wherein a length of each of the first laser spots (LS1) and the second laser spots (LS2) in the thickness direction (DR3) of the cover window (CW) is about 2 µm to about 20 µm.

10. The method of claim 8 or 9, wherein in the thickness direction (DR3) of the cover window (CW), a distance (Dz1) between centers of two neighboring first laser spots (LS1) among the first laser spots (LS1) is about 5 µm to about 15 µm.

11. The method of at least one of claims 8 to 10, wherein a distance (Dx1) between neighboring first laser spots (LS1) among the first laser spots (LS1) in a direction orthogonal to the thickness direction (DR3) of the cover window (CW) and orthogonal to a scanning direction of the laser device (LD) is about 0 µm to about 2 µm, and a distance (Dy1) between neighboring first laser spots (LS1) among the first laser spots (LS1) in the scanning direction of the laser device (LD) is about 5 µm to about 15 µm, and
wherein a distance (Dy2) between neighboring second laser spots (LS2) among the second laser spots (LS2) in the scanning direction of the laser device (LD) is about 5 µm to about 15 µm.

12. The method of at least one of claims 8 to 11, wherein at least two second laser spots (LS2) among the second laser spots (LS2) overlap each other in the thickness direction (DR3) of the cover window (CW).

13. The method of at least one of claims 8 to 12, wherein a minimum distance (Dmin) between the first laser spots (LS1) and the second laser spots (LS2) in a direction orthogonal to the thickness direction (DR3) of the cover window (CW) and orthogonal to a scanning direction of the laser device (LD) is about 3 µm or greater.

14. The method of at least one of claims 7 to 13, wherein the scanning of the laser beam (BM) multiple times in the area corresponding to any one of the cover windows (CW) comprises:
scanning the laser beam (BM) along a first side virtual line (VSS1) corresponding to a first side surface (SS1) of the cover window (CW) with the laser device (LD) rotated 0 degrees;
scanning the laser beam (BM) along a first corner virtual line (VCS1) corresponding to a first corner side surface (CS1) between the first side surface (SS1) and a second side surface (SS2) of the cover window (CW) while rotating the laser device (LD) from 0 degrees to about 90 degrees;
scanning the laser beam (BM) along a second side virtual line (VSS2) corresponding to the second side surface (SS2) of the cover window (CW) with the laser device (LD) rotated about 90 degrees;
scanning the laser beam (BM) along a second corner virtual line (VCS2) corresponding to a second corner side surface (CS2) between the second side surface (SS2) and a third side surface (SS3) of the cover window (CW) while rotating the laser device (LD) from about 90 degrees to about 180 degrees;
scanning the laser beam (BM) along a third side virtual line (VSS3) corresponding to the third side surface (SS3) of the cover window (CW) with the laser device (LD) rotated about 180 degrees;
scanning the laser beam (BM) along a third corner virtual line (VCS3) corresponding to a third corner side surface (CS3) between the third side surface (SS3) and a fourth side surface (SS4) of the cover window (CW) while rotating the laser device (LD) from about 180 degrees to about 270 degrees;
scanning the laser beam (BM) along a fourth side virtual line (VSS4) corresponding to the fourth side surface (SS4) of the cover window (CW) with the laser device (LD) rotated about 270 degrees; and
scanning the laser beam (BM) along a fourth corner virtual line (VCS4) corresponding to a fourth corner side surface (CS4) between the fourth side surface (SS4) and the first side surface (SS1) of the cover window (CW) while rotating the laser device (LD) from about 270 degrees to about 360 degrees.

15. The method of claim 14, wherein the laser device (LD) outputs an elliptically polarized laser beam along the first side virtual line (VSS1), the first corner virtual line (VCS1), and the second side virtual line (VSS2).

16. The method of claim 14 or 15, wherein the laser device (LD) outputs an elliptically polarized laser beam along the second corner virtual line (VCS2), the third side virtual line (VSS3), the third corner virtual line (VCS3), the fourth side virtual line (VSS4), and the fourth corner virtual line (VCS4).

17. The method of at least one of claims 5 to 16, wherein a plurality of etch pores (POR) are formed on each of the side surfaces (SS1-SS4) of each of the cover windows (CW) by the etchant (ETL).

18. The method of claim 17, wherein a difference between a maximum height and a minimum height of the etch pores (POR) in a direction in which each of the side surfaces (SS1-SS4) of each of the cover windows (CW) extends is about 0.1 µm to about 0.5 µm.

19. The method of at least one of claims 5 to 18, wherein the thickness of each of the cover windows (CW) is reduced by about 20 % to about 50% by the etchant (ETL).

20. An electronic device (11, 10.1a-e, 10.2a-c, 10.3) comprising:
a display panel (100) comprising a bendable folding area (FDA) and a non-folding area (NFA1, NFA2) around or beside the folding area (FDA); and
a cover window (CW) according to at least one of claims 1 to 4 on a surface of the display panel (100).
